# EUROPEAN PATENT APPLICATION

(11) **EP 4 835 353 A1**
(43) Date of publication of application: **04.11.2026**
(21) Application number: 24913688.8
(22) Date of filing: 27.12.2024
(51) Int. Cl.: F21V 29/51, F21V 29/74, F21V 29/71, F21V 29/83, F21V 29/89, F21V 29/60, F21V 19/00, F21V 29/503, H05K 7/20, F21V 17/10

(54) **LIGHTING APPARATUS**

(30) Priority: 29.12.2023 KR 20230196873; 16.04.2024 KR 20240050969
(71) Applicant: Gigatera Lighting Inc., Hwaseong-si, Gyeonggi-do 18462 (KR)
(72) Inventor: HAN, Jong Ju, Hwaseong-si Gyeonggi-do 18503 (KR); CHOI, Pyoung Hwa, Hwaseong-si Gyeonggi-do 18476 (KR); HAN, Yong Hee, Osan-si Gyeonggi-do 18114 (KR)
(74) Representative: impuls legal PartG mbB
(86) International application number: PCT/KR2024/021299
(87) International publication number: WO 2025/143884

(57) **Abstract**

The present invention relates to a lighting apparatus and includes: an LED unit which generates and emits predetermined light; a lighting body which is made of a thermally conductive material and has an installation space with an open front side to install the LED unit and has on the rear portion thereof a plurality of press-fitting portions which are integrally formed in the form of a pair of slot ribs long in the vertical direction; and a plurality of heat dissipation units which have formed therein a refrigerant flow space filled with a refrigerant therein and are press-fitted and installed in a press-fitting manner such that at least a portion of the refrigerant flow space is positioned inside the pair of slot ribs of the press-fitted portions. Accordingly, heat dissipation performance may be improved.

## Description

### [Technical Field]

The present disclosure relates to a lighting apparatus, and more particularly, to a lighting apparatus that can maximize light distribution performance and heat dissipation performance by including a heat dissipation unit configured to effectively dissipate heat generated from an LED unit.

### [Background Art]

In various industrial fields such as communications, electronics, and electricity, related technologies are continuously being developed to a high level for application to more advanced industries. In order to develop highly advanced technologies, high-output energy is required, and devices that use high-output energy inevitably face the problem of high heat generation. Thus, the development of a cooling system at an appropriate level should be accompanied therewith.

The cooling system is used in various industries, including air conditioners, mobile communications, data centers, air mobility, electric vehicles, energy storage devices, displays, and lighting apparatuses. Such a cooling system is one of the major causes of power consumption, and the power consumption is gradually increasing as industries continue to develop.

In general, a cooling device may be broadly classified into an active cooling device and a passive cooling device. The active cooling device mainly utilizes forced convection generated by a fan, whereas the passive cooling device may be classified as a technology that utilizes natural convection without using a fan.

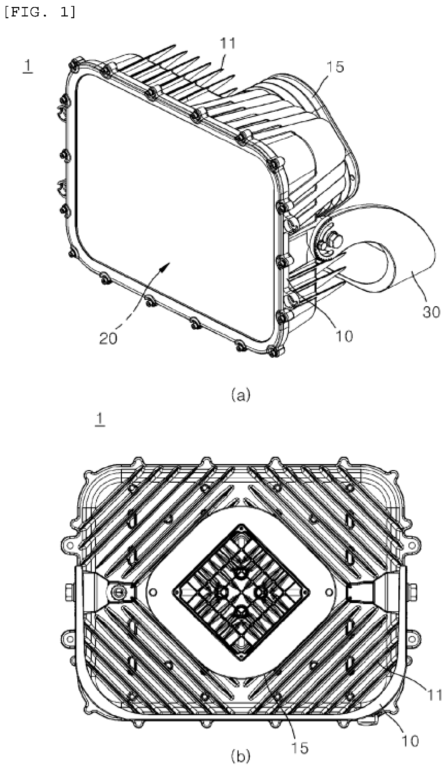

FIG. 1 is a perspective view illustrating a heat dissipation system using the thermal conductivity of the material itself of a heat dissipation unit in the form of a heat sink fin, as an example of a lighting apparatus according to the related art.

As shown in FIG. 1, the lighting apparatus may include a lighting body 10, an LED unit 20 installed inside the lighting body 10 to generate and emit predetermined light, and heat dissipation units 11 and 15 provided on a rear surface of the lighting body 10 and provided in the shape of a plurality of heat sink fins to dissipate heat generated from the LED unit 20 to the outside.

In particular, the lighting apparatus 1 shown in FIG. 1 is a spot light that emits a relatively narrow beam. Such a spot light may achieve a desired light distribution effect as the size of a light source is reduced, but may be very disadvantageous for heat dissipation.

Furthermore, in the lighting apparatus based on the LED unit 20 on which a plurality of LED elements are mounted, the absolute temperature of the LED elements should be low to secure desired light distribution performance, but there should be no temperature deviation (relative temperature) among the LED elements. If the temperature deviation among the LED elements is large, the lifespan of the lighting apparatus 1 is reduced, and the light distribution performance is also degraded.

The lighting apparatus 1 according to the related art shown in FIG. 1 is provided with two types of heat dissipation units 11 and 15 so as to minimize the temperature deviation among the LED elements of the LED unit 20.

That is, the heat dissipation units 11 and 15 include an integral heat sink fin 11 integrally formed around a rearside center of the lighting body 10 having a substantially square casing shape with an open front surface, and a detachable heat sink fin 15 detachably provided at the rearside center of the lighting body 10.

The reason why the lighting body 10 is additionally provided with a separate detachable heat sink fin 15 on the rear surface thereof in addition to the integral heat sink fin 11 is to actively dissipate heat concentrated on the central portion, thereby minimizing the temperature deviation among the LED elements when dissipating heat generated from the LED unit 20.

On the other hand, in order to minimize the temperature deviation among the LED elements without the provision of the separate detachable heat sink fin 15 described above, the spacing between the LED elements may be increased. However, this inevitably leads to an increase in the size and weight of a product, thereby deteriorating on-site installation workability and impairing the design flexibility of a fixing bracket 30 for fixing the product.

### [Disclosure]

### [Technical Problem]

The present disclosure is proposed to resolve the aforementioned technical issues and is directed to providing a lighting apparatus including a heat dissipation unit capable of effectively dissipating heat generated from an LED unit.

Further, the present disclosure is directed to providing a lighting apparatus capable of preventing an increase in product size by preventing a temperature deviation between LED elements even when the plurality of LED elements are closely spaced.

Further, the present disclosure is directed to providing a lighting apparatus capable of preventing deterioration of light distribution performance by enabling a plurality of LED elements constituting an LED unit to be densely arranged.

Technical issues of the present disclosure are not limited to the technical issues mentioned above, and other technical issues not mentioned above will be clearly understood by those skilled in the art from the following description.

### [Technical Solution]

A lighting apparatus according to an embodiment of the present disclosure includes an LED unit configured to generate and emit predetermined light, a lighting body made of a thermally conductive material, the lighting body having an installation space with an open front side for installing the LED unit, and a plurality of press-fitting portions integrally formed on a rear surface thereof in the form of a pair of slot ribs extending in a vertical direction, and a plurality of heat dissipation units, each having a refrigerant flow space formed therein and filled with a refrigerant, the heat dissipation units being press-fitted into the press-fitting portions by an interference-fit method such that at least a portion of the refrigerant flow space is positioned within the pair of slot ribs of the corresponding press-fitting portion.

Here, the heat dissipation unit may include a first-side heat conduction panel forming one side surface of the refrigerant flow space in a thickness direction, and a second-side heat conduction panel forming the other side surface of the refrigerant flow space in the thickness direction, and the refrigerant flow space may be formed by joining the first-side heat conduction panel and the second-side heat conduction panel along peripheral edges thereof, the first-side and second-side heat conduction panels being formed of two metal panel members, or by bending a single metal panel member and then joining the first-side heat conduction panel and the second-side heat conduction panel to each other along peripheral edges thereof.

Further, the metal panel members constituting the first-side heat conduction panel and the second-side heat conduction panel may be made of SUS (stainless steel).

Further, the refrigerant flow space provided in the heat dissipation unit may include a first refrigerant flow path provided in an evaporation region in which liquid refrigerant of the refrigerant is stored and the stored liquid refrigerant is phase-changed into a gas state by heat supplied from the LED unit, and a plurality of second refrigerant flow paths formed toward the first refrigerant flow path in a direction of gravity or inclined with respect to the direction of gravity, and configured to guide the liquid refrigerant of the refrigerant, which has been phase-changed from the gas state to the liquid state, to flow toward the first refrigerant flow path.

Further, the refrigerant may be water capable of undergoing a phase change from the liquid state to the gas state or from the gas state to the liquid state by thermal conductivity of the first-side heat conduction panel forming one side surface of the refrigerant flow space and the second-side heat conduction panel forming the other side surface of the refrigerant flow space.

Further, when the first refrigerant flow path of each of the plurality of heat dissipation units is press-fitted into a corresponding one of the plurality of press-fitting portions arranged on the rear surface of the lighting body so as to be spaced apart from each other in a left-right direction, the first refrigerant flow path may be arranged vertically in an up-down direction corresponding to the direction of gravity.

Further, the plurality of second refrigerant flow paths may be respectively defined to be partitioned from adjacent second refrigerant flow paths by a plurality of inclined guides protruding inwardly into the refrigerant flow space from the first-side heat conduction panel forming one side surface of the refrigerant flow space and the second-side heat conduction panel forming the other side surface of the refrigerant flow space.

Further, in the second refrigerant flow path or the plurality of inclined guides, at least one of a first end and a second end may be connected to the first refrigerant flow path, and an end connected to the first refrigerant flow path may be positioned relatively lower in the direction of gravity.

Further, in the second refrigerant flow path or the plurality of inclined guides, at least one of the first end and the second end may be connected to the first refrigerant flow path, and the first end and the second end may be connected in a straight line.

In addition, the refrigerant flow space may further include a plurality of third refrigerant flow paths defined as portions of opposing surfaces of the first-side heat conduction panel and the second-side heat conduction panel at which the plurality of inclined guides are formed, the portions being spaced apart from each other without being joined within the refrigerant flow space.

Further, liquid refrigerant condensed in a condensation region other than the evaporation region may flow in the liquid state in the direction of gravity along the plurality of inclined guides defining the second refrigerant flow paths, and gas refrigerant evaporated in the evaporation region may flow in the gas state through spaces between the plurality of inclined guides defining the third refrigerant flow paths.

Further, the first-side heat conduction panel and the second-side heat conduction panel may be formed with a plurality of strength reinforcing portions protruding so as to be in surface contact with each other within the refrigerant flow space, thereby reinforcing the strength of the first-side heat conduction panel and the second-side heat conduction panel.

Further, the plurality of strength reinforcing portions may be formed such that end surfaces thereof protrude into the refrigerant flow space by at least a greater extent than leading ends of the plurality of inclined guides.

Further, the plurality of strength reinforcing portions may be joined at portions thereof that are in surface contact with each other within the refrigerant flow space by a joining process including a laser welding process, thereby forming the refrigerant flow space between the first-side heat conduction panel and the second-side heat conduction panel.

In addition, the heat dissipation unit may further include an absorber disposed within the first refrigerant flow path and having a plurality of pores to absorb liquid refrigerant within the refrigerant flow space and then evaporate the absorbed liquid refrigerant into gas refrigerant using heat transferred from the LED unit.

In addition, the heat dissipation unit may further include at least one auxiliary absorber disposed in a second refrigerant flow path on adjacent inclined guides among the plurality of inclined guides, the auxiliary absorber being configured to collect liquid refrigerant and supply the collected liquid refrigerant to the absorber.

In addition, the lighting apparatus may further include an angle adjustment unit disposed at a lower end of the lighting body and configured to adjust an irradiation direction of the LED unit.

Further, the angle adjustment unit may include a fixing bracket configured to fix the lighting body at a predetermined position, a steering block configured to be steered and rotated in a left-right direction with respect to the fixing bracket about a vertical axis, and a tilting block configured to be tilted and rotated in a front-rear direction with respect to the steering block via a horizontal left-right coupling shaft, the tilting block being connected to a lower end of the lighting body.

Further, the steering block may be rotatably coupled to the fixing bracket through a fixing panel coupled to a lower portion of the fixing bracket while a lower end of the steering block is inserted into an installation hole formed through the fixing bracket in an up-down direction.

Further, the steering block may be provided with a steering worm wheel gear having a plurality of worm wheel gear teeth formed on a portion of an outer circumferential surface thereof, the fixing bracket may be rotatably provided with a steering worm gear having worm gear teeth formed thereon to be engageable with the worm wheel gear teeth of the steering worm wheel gear, and the steering block may be steered and rotated in a left-right direction as the steering worm gear rotates about an axis thereof.

Further, the steering block may be provided with a tilting worm wheel gear having a plurality of worm wheel gear teeth formed on a portion of an outer circumferential surface thereof, the tilting block may be rotatably provided with a tilting worm gear having worm gear teeth formed thereon so as to be engageable with the worm wheel gear teeth of the tilting worm wheel gear, and the tilting block may be tilted and rotated in a front-rear direction as the tilting worm gear rotates about an axis thereof.

Further, the angle adjustment unit may include a housing base panel part configured to fix the lighting body, which requires tilting or steering adjustment, at a predetermined position, a steering base panel configured to be steered and rotated in a left-right direction with respect to the housing base panel part about a steering shaft extending in a vertical direction, and a tilting bracket panel configured to be tilted and rotated in a front-rear direction with respect to the steering base panel via a horizontally extending tilting shaft, the tilting bracket panel being connected to a lower end of the lighting body.

Further, the angle adjustment unit may include a tilting rotation panel part fixed to the lighting body and configured to tilt and rotate in a front-rear direction in conjunction with the lighting body, and a steering rotation panel part steerably and rotatably coupled to an installation portion on which the lighting apparatus is installed and configured to provide any left-right horizontal axis to the tilting rotation panel part.

### [Advantageous Effects]

According to an embodiment of the present disclosure, a lighting apparatus may achieve various effects as follows.

First, the density of LED elements mounted on an LED unit can be concentrated, and heat dissipation performance can be improved by a heat dissipation unit having a refrigerant flow space filled with a phase-changeable refrigerant, thereby eliminating the need for an additional heat dissipation structure for concentrated heat dissipation at a central portion.

Second, the overall size of a product can be reduced, and the weight thereof can also be reduced.

### [Description of Drawings]

FIG. 1 is a perspective view illustrating a heat dissipation system using the thermal conductivity of the material itself of a heat dissipation unit in the form of a heat sink fin, as an example of a lighting apparatus according to the related art;
FIGS. 2A and 2B are front and rear perspective views illustrating a lighting apparatus according to an embodiment of the present disclosure;
FIGS. 3A and 3B are exploded perspective views of FIGS. 2A and 2B, respectively, illustrating a state in which the heat dissipation unit is separated from a lighting body;
FIGS. 4A and 4B are exploded perspective views of FIGS. 2A and 2B, respectively, illustrating a state in which the heat dissipation unit is coupled to the lighting body;
FIG. 5 is a cross-sectional view taken along line A-A of FIG. 2A;
FIGS. 6A and 6B are front and rear perspective views illustrating the lighting body among components of FIGS. 2A and 2B;
FIGS. 7A and 7B are exploded perspective views of FIGS. 6A and 6B, respectively;
FIG. 8 is an exploded perspective view illustrating installation of the heat dissipation unit on a rear portion of the lighting body;
FIG. 9 is a perspective view illustrating the heat dissipation unit for dissipating heat from a lighting apparatus according to an embodiment of the present disclosure;
FIG. 10 is an exploded perspective view of FIG. 9;
FIG. 11 is a perspective view illustrating a state in which one-side heat conduction panel among components of the heat dissipation unit of FIG. 9 is removed;
FIG. 12 is a cross-sectional view taken along line B-B of FIG. 9;
FIG. 13 is a perspective view illustrating one implementation of an angle adjustment unit among components of the lighting apparatus according to an embodiment of the present disclosure;
FIG. 14 is an exploded perspective view of FIG. 13;
FIGS. 15A and 15B are partial perspective views for explaining an operation of the angle adjustment unit by tilting rotation and steering rotation;
FIG. 16 is a perspective view illustrating a lighting apparatus according to another embodiment of the present disclosure;
FIGS. 17A and 17B are front and rear exploded perspective views for explaining a finger guard panel assembly among components of FIG. 16;
FIG. 18 is a rear perspective view illustrating a state in which another implementation of the angle adjustment unit is installed in the configuration of the lighting apparatus according to an embodiment of the present disclosure;
FIG. 19 is an exploded perspective view of FIG. 18;
FIG. 20 is a perspective view illustrating another implementation of the angle adjustment unit among the components of the lighting apparatus according to an embodiment of the present disclosure;
FIG. 21 is an exploded perspective view of FIG. 20;
FIG. 22 is a rear perspective view illustrating a state in which still another implementation of the angle adjustment unit is installed in in the configuration of the lighting apparatus according to an embodiment of the present disclosure;
FIG. 23 is an exploded perspective view of FIG. 22;
FIG. 24 is a perspective view illustrating still another implementation of the angle adjustment unit among the components of the lighting apparatus according to an embodiment of the present disclosure; and
FIG. 25 is an exploded perspective view of FIG. 24.

### <Description of reference numerals>

| | | | |
|---|---|---|---|
| 100: | Lighting apparatus | 110: | Lighting body |
| 120: | Light-transmitting panel | 130: | Press-fitting portion |
| 150: | LED unit | 200: | Heat dissipation unit |
| 210: | First refrigerant flow Path | 215: | Inclined guide |
| 220: | Second refrigerant flowpath | 230: | Third refrigerant flow path |
| 240: | Multiple strength reinforccing portions | 300: | Absorber |
| 3011: | Auxiliary absorber | 500: | assembly Finger guard panel |
| 600: | Angle adjustment unitaccordingto one implementation | | |
| 610: | Fixing bracket | 620: | Steeriblock |
| 630: | Tilting block | | |
| 1600: | Angle adjustment unit accordto another implementation | | |
| 2600: | Angle adjustment unit accordingto still another implementation | | |

### [Mode for Invention]

Hereinafter, a lighting apparatus according to embodiments of the present disclosure will be described in detail with reference to the accompanying drawings.

It is to be noted that in assigning reference numerals to elements in the drawings, the same reference numerals denote the same elements as much as possible even in cases where the elements are shown in different drawings. Furthermore, in describing the embodiments of the present disclosure, a detailed description of the known configurations or functions will be omitted if it is deemed to obscure the understanding for the embodiments of the present disclosure.

In describing the elements of an embodiment of the present disclosure, terms, such as the first, the second, A, B, (a), and (b) may be used. However, the terms are used only to distinguish one element from the other element, and the essence, order, or sequence of the elements is not limited by the terms. Furthermore, unless otherwise defined, all terms used herein including technical or scientific terms have the same meanings as generally understood by those skilled in the art to which the present disclosure pertains. The terms, such as terms defined in dictionaries, which are generally used, should be construed as having meanings identical to contextual meanings of the related art, and are not construed as having ideal or excessively formal meanings unless they are definitely defined in the present disclosure.

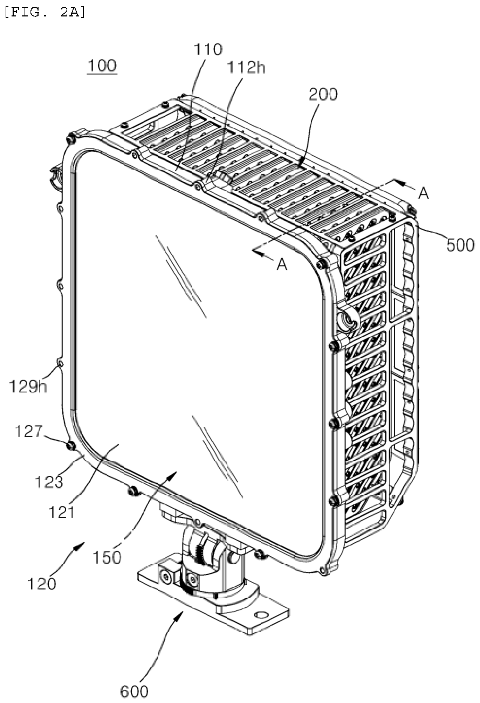

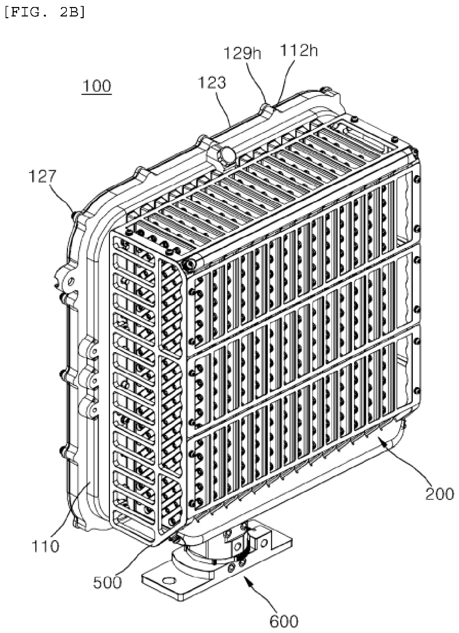

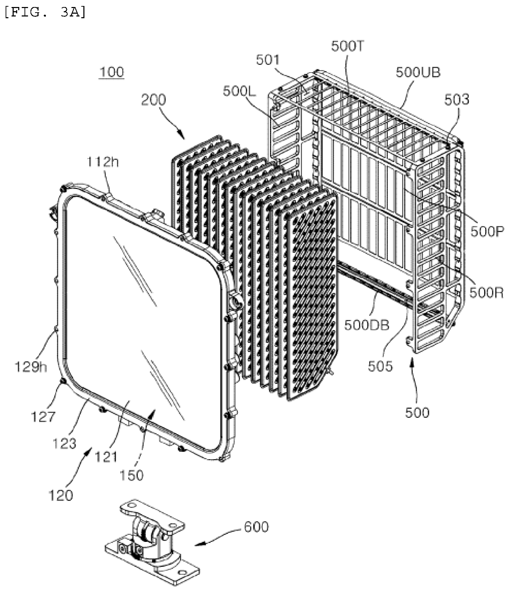

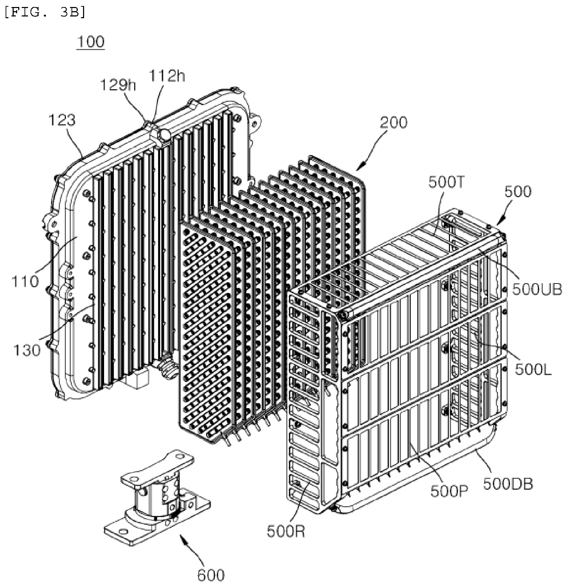

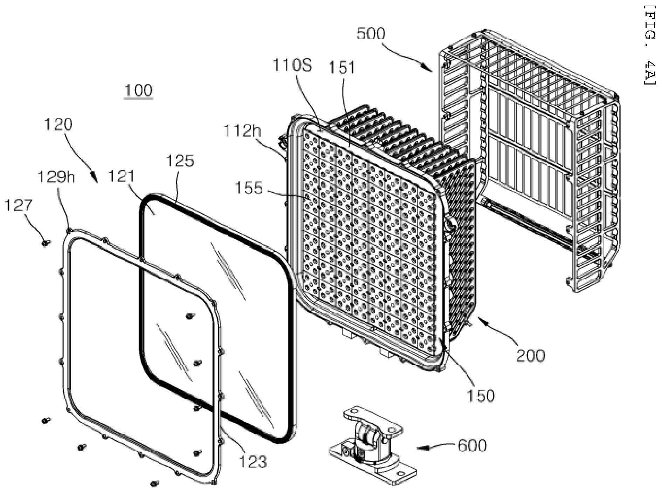

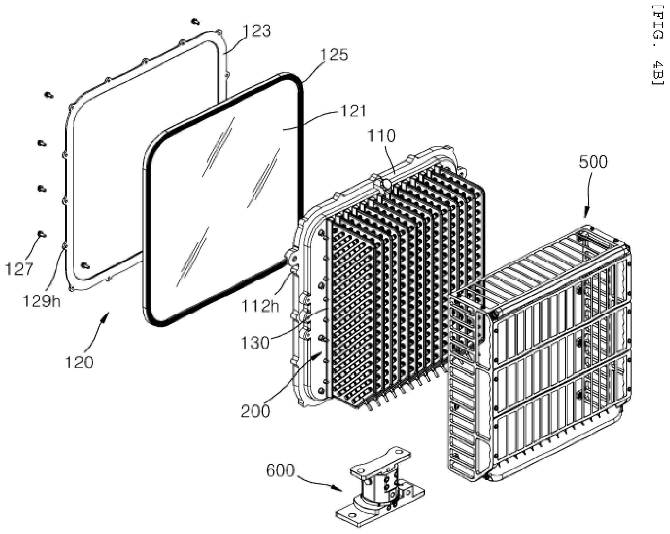

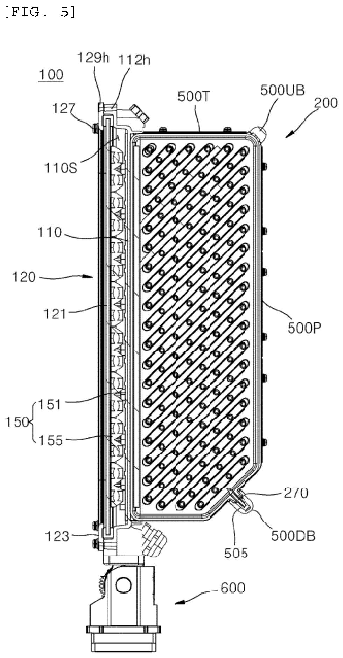

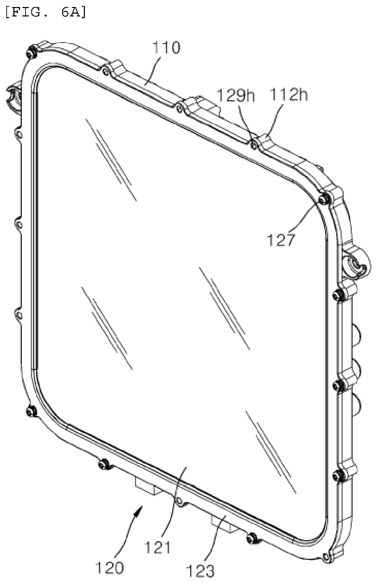

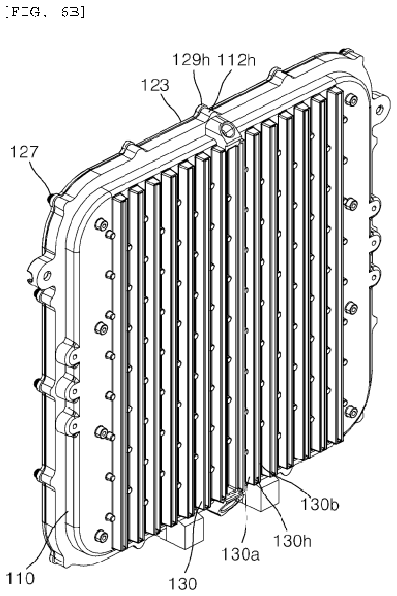

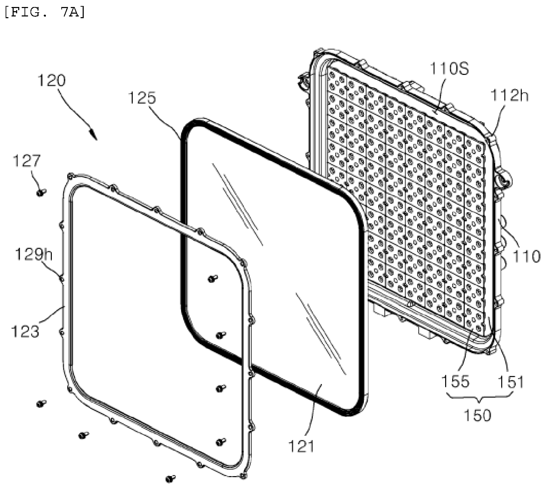

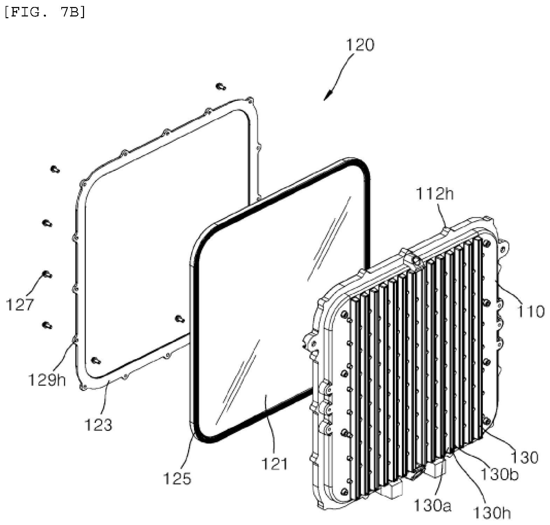

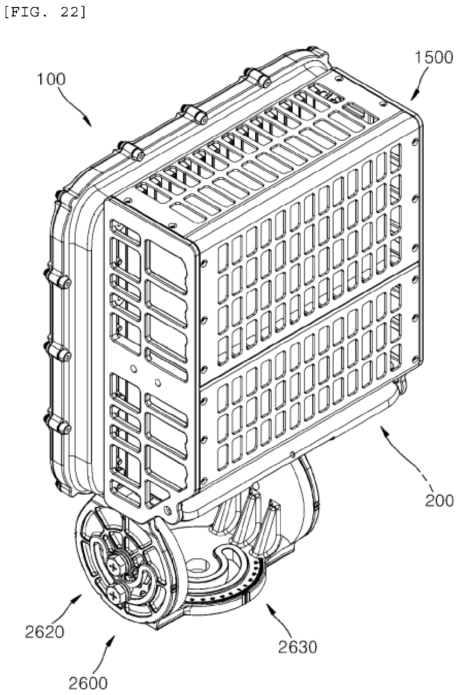

FIGS. 2A and 2B are front and rear perspective views illustrating a lighting apparatus according to an embodiment of the present disclosure, FIGS. 3A and 3B are exploded perspective views of FIGS. 2A and 2B, respectively, illustrating a state in which the heat dissipation unit is separated from a lighting body, FIGS. 4A and 4B are exploded perspective views of FIGS. 2A and 2B, respectively, illustrating a state in which the heat dissipation unit is coupled to the lighting body, FIG. 5 is a cross-sectional view taken along line A-A of FIG. 2A, FIGS. 6A and 6B are front and rear perspective views illustrating the lighting body among components of FIGS. 2A and 2B, and FIGS. 7A and 7B are exploded perspective views of FIGS. 6A and 6B, respectively.

As illustrated in FIGS. 2A to 6B, a lighting apparatus 1 according to an embodiment of the present disclosure includes a lighting body 110 having a substantially rectangular (or square) vertical cross-sectional shape, a reduced thickness in a front-rear direction, and an open front surface, and an LED unit 150 seated and coupled inside the lighting body 110 and including an LED board 151 on which a plurality of LED elements 155 are mounted.

An installation space 110S for stacking installation of the above-described LED unit 150 may be provided at a front portion of the lighting body 110 in the form of a groove having an opened front side, and a plurality of press-fitting portions 130 for press-fitting installation of the heat dissipation unit 200 to be described later may be integrally formed at a rear portion of the lighting body 110.

In addition, a plurality of screw fastening holes 112h for screw assembly of a light-transmitting panel 120 to be described later may be formed to be spaced apart from each other along a front edge of the lighting body 110.

Meanwhile, the lighting apparatus 100 according to an embodiment of the present disclosure, as illustrated in FIGS. 4A to 7B, may further include the light-transmitting panel 120 made of a transparent material (or a translucent material) that transmits forward the light generated from the LED unit 150, the light-transmitting panel covering the open front surface of the lighting body 110.

More specifically, as illustrated in FIGS. 7A and 7B, the light-transmitting panel 120 may include a light-transmitting glass 121 provided in the form of a panel made of a transparent material (or a translucent material), a fixing frame 123 that mediates screw assembly of the light-transmitting glass 121 to a front end of the lighting body 110 using a plurality of fixing screws 127, and a waterproof gasket 125 interposed between the fixing frame 123 and an edge of the front end of the lighting body 110 to perform a waterproof function.

A plurality of screw through-holes 129h may be formed along a peripheral edge of the fixing frame 123 at positions respectively corresponding to the plurality of screw fastening holes 112h formed at the front end of the lighting body 110 so that the above-described fixing screws 127 pass therethrough.

Here, the waterproof gasket 125 may be made of a rubber material. When fastening force of the fixing screws 127 is applied to the fixing frame 123, the waterproof gasket is compressively deformed to prevent foreign substances, including rainwater, from entering the interior.

Meanwhile, as described above, the plurality of press-fitting portions 130 may be integrally formed on a rear portion of the lighting body 110.

The plurality of press-fitting portions 130 are portions at which a plurality of heat dissipation units 200 to be described later are detachably installed, and may be provided in the form of a pair of slot ribs 130a and 130b having front ends protruding rearward by a predetermined length from a rear portion of the lighting body 110. The heat dissipation unit 200 may be press-fitted in an interference-fit manner into an installation groove 130h formed between the pair of slot ribs 130a and 130b such that a part thereof (e.g., a part of a refrigerant flow space 205 to be described later) is positioned therein.

The heat dissipation unit 200 corresponds to a core heat dissipation means of an electronic device which, like the lighting apparatus 100 according to an embodiment of the present disclosure, generate a large amount of heat during operation and whose lifespan is determined depending on whether the heat is rapidly dissipated to the outside. The most important design factor is to design the heat dissipation unit so that no temperature deviation occurs among the LED elements 155 constituting the LED unit 150.

In particular, in the case of a spot light provided to emit a narrow beam, small-sized light sources (LED elements 155) are densely mounted, and a layout design of the heat dissipation unit 200 for minimizing temperature deviation thereof is more urgently required.

The lighting apparatus 100 according to an embodiment of the present disclosure, as illustrated in FIGS. 2A to 7B, may further include the plurality of heat dissipation units 200, which are press-fitted into the press-fitting portions 130 formed on the rear portion of the lighting body 110.

In addition, an angle adjustment unit 600 may be coupled to a lower side of the lighting body 110 to adjust an irradiation angle with respect to a lighting direction of the lighting body 110. A detailed configuration and function of the angle adjustment unit 600 will be described in greater detail later.

Meanwhile, a finger guard panel assembly 500 according to an implementation, which is provided to cover all portions of the plurality of heat dissipation units 200 except for lower ends thereof and is provided in a grill form to allow outside air (outdoor air) to pass therethrough for heat exchange with the heat dissipation units 200, may be further coupled to the rear portion of the lighting body 110.

As illustrated in FIGS. 3A and 3B, the finger guard panel assembly 500 may include a left finger guard panel 500L covering a left side of the plurality of heat dissipation units 200, a right finger guard panel 500R covering a right side of the plurality of heat dissipation units 200, a rear finger guard panel 500P connected to rear ends of the left finger guard panel 500L and the right finger guard panel 500R and covering rear portions of the plurality of heat dissipation units 200, and the upper finger guard panel 500T covering upper ends of the plurality of heat dissipation units 200.

In addition, the finger guard panel assembly 500 may further include a lower horizontal support bar 500DB connected to and supporting lower ends of the left finger guard panel 500L, the right finger guard panel 500R, and the rear finger guard panel 500P, and an upper horizontal support bar 500UB connected to and supporting upper ends of the left finger guard panel 500L, the right finger guard panel 500R, and the rear finger guard panel 500P.

Here, each of the finger guard panels 500L, 500R, 500P, and 500T may have mutually contacting ends screw-fastened using a plurality of fixing screws 503, or may have mutually contacting ends screw-fastened using a plurality of fixing screws (not shown) via the lower horizontal support bar 500DB or the upper horizontal support bar 500UB.

Meanwhile, as illustrated in FIG. 5, a seating groove 505 inclined downward from a front portion toward a rear portion is formed in the lower horizontal support bar 500DB, and an air vent tube 270 among the components of the heat dissipation unit 200 to be described later may be accommodated in the seating groove 505 so as to be protected from the outside.

Each of the finger guard panels 500L, 500R, 500P, and 500T of the finger guard panel assembly 500 according to an implementation may be provided in the form of a panel having a plurality of ventilation holes 501 of a size that facilitates inflow of outdoor air and outflow of indoor air with respect to the heat dissipation unit 200 to be protected therein, while preventing access of skin, including a finger of an external worker.

However, the respective finger guard panels 500L, 500R, 500P, and 500T, which are main components of the finger guard panel assembly 500, are not necessarily provided in the panel form, and some components may be replaced with a configuration such as a support pipe 510 within a range that maintains a frame structure, as in a finger guard panel assembly 500-1 according to another implementation to be described later. This will be described in greater detail later.

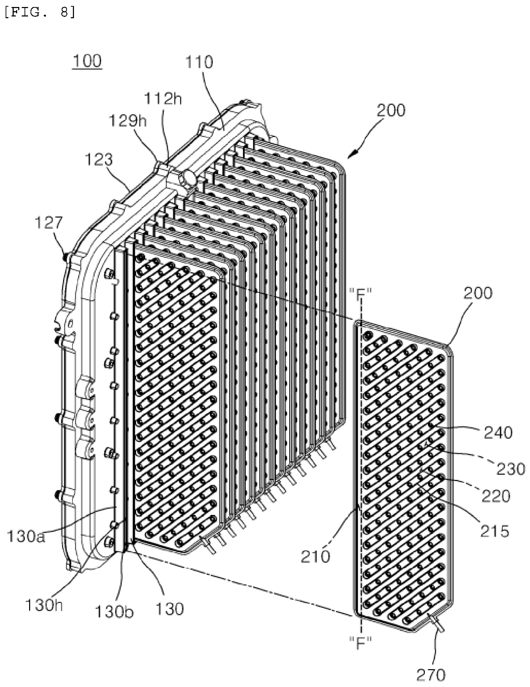

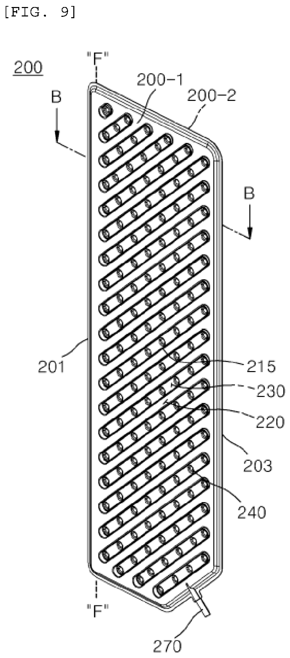

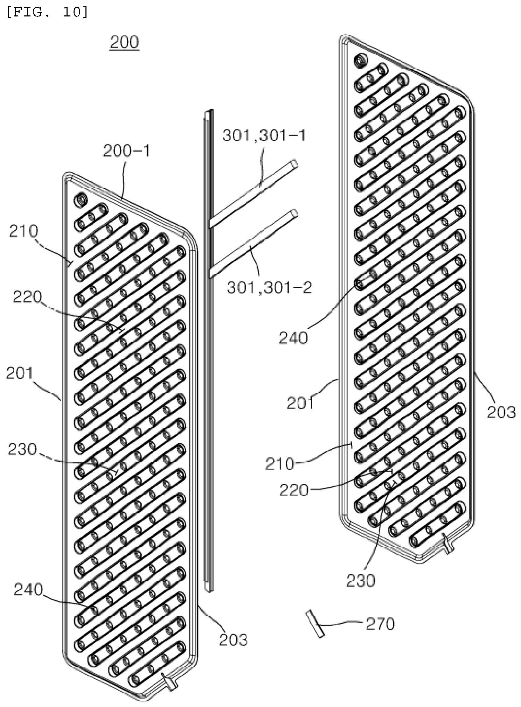

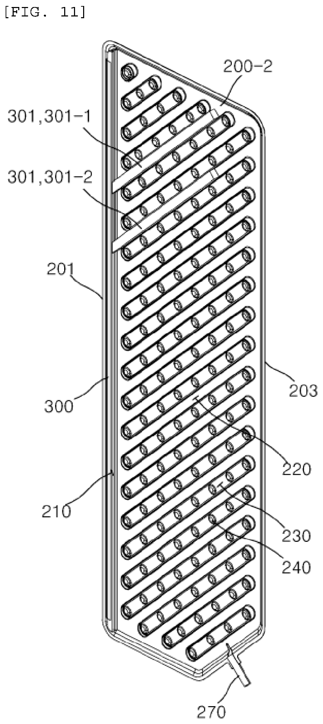

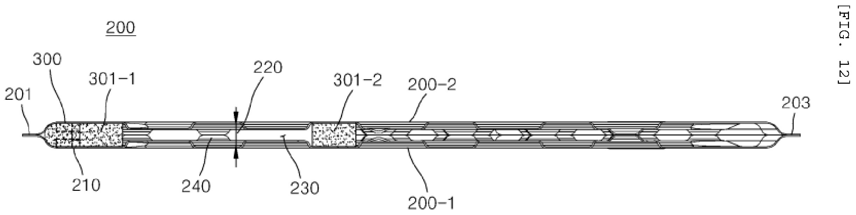

FIG. 8 is an exploded perspective view illustrating a state in which the heat dissipation unit is installed on the rear portion of the lighting body, FIG. 9 is a perspective view illustrating the heat dissipation unit for dissipating heat of the lighting apparatus according to an embodiment of the present disclosure, FIG. 10 is an exploded perspective view of FIG. 9, FIG. 11 is a perspective view illustrating a state in which a one-side heat conduction panel among components of the heat dissipation unit of FIG. 9 is removed, and FIG. 12 is a cross-sectional view taken along line B-B of FIG. 9.

The heat dissipation unit 200, as illustrated in FIG. 8, may be arranged to extend lengthwise in a vertical (up-and-down) direction on the rear portion of the lighting body 110, and a plurality of heat dissipation units may be arranged in a left-right direction of the lighting body 110 so as to be spaced apart from each other by a predetermined distance.

For installation of the plurality of heat dissipation units 200, the press-fitting portions 130 provided at the rear portion of the lighting body 110 may also be arranged to extend lengthwise in a vertical (up-and-down) direction, and the respective press-fitting portions 130 may be arranged in parallel with each other while being spaced apart by a predetermined distance in a left-right direction.

According to the press-fitting portions 130 configured as described above, an upward airflow generated by the heat dissipation units 200 at the rear portion of the lighting body 110 has an advantage in heat dissipation design by minimizing flow resistance in a directly upward direction.

Meanwhile, the heat dissipation unit 200 may form a refrigerant flow space 205 filled with the refrigerant therein, as illustrated in FIGS. 8 to 12.

As illustrated in FIGS. 9 to 12, the heat dissipation unit 200 may include a one-side heat conduction panel 200-1 forming one side surface in a thickness direction of the refrigerant flow space 205 and an other-side heat conduction panel 200-2 forming the other side surface in the thickness direction of the refrigerant flow space 205.

Here, the refrigerant flow space 205 may be formed by bonding the one-side heat conduction panel 200-1 and the other-side heat conduction panel 200-2, formed of two metal panel members, along peripheral edges thereof, or by bending a single metal panel member and then bonding peripheral edges thereof except for bent portions of the one-side heat conduction panel 200-1 and the other-side heat conduction panel 200-2 that are mutually joined.

Meanwhile, as illustrated in FIGS. 9 to 12, the refrigerant flow space 205 may include a first refrigerant flow path 210 corresponding to an evaporation region in which liquid refrigerant of the refrigerant is stored (retained) and the stored (retained) liquid refrigerant undergoes a phase change (evaporation) into a gas state by heat supplied from the LED unit 150, the first refrigerant flow path being formed to extend lengthwise in a vertical direction, and a second refrigerant flow path 220 that is a flow path of liquid refrigerant and is formed in a condensation region other than the evaporation region. One end of the second refrigerant flow path may communicate with the first refrigerant flow path 210, and the other end thereof may be inclined in a rearward oblique direction to be positioned higher in a gravitational direction than the one end, thereby guiding liquid refrigerant that has been phase-changed by condensation from a gas state in the condensation region to flow toward the first refrigerant flow path 210.

Hereinafter, a region which is positioned close to the LED unit 150 and in which liquid refrigerant undergoes a phase change into gas refrigerant by heat supplied from the LED unit 150 may be defined as the above-described "evaporation region," and an entire portion of the refrigerant flow space 205 excluding the evaporation region may be defined as the above-described "condensation region," in which gas refrigerant undergoes a phase change into liquid refrigerant. The first refrigerant flow path 210 may be located in a portion corresponding to the evaporation region, and the second refrigerant flow path 220 may be located in a portion corresponding to the condensation region.

Further, one end at which the first refrigerant flow path 210 is located as the evaporation region may be defined as the "press-fitting end 201" in that it is installed in the press-fitting portion 130 provided at the rear portion of the lighting body 110 described above, and peripheral edges other than the press-fitting end 201 may be defined as a "heat dissipation plate portion 203" in that they perform heat dissipation through substantial heat exchange with outdoor air.

In particular, the first refrigerant flow path 210 may be a position in which liquid refrigerant of the refrigerant is filled, with only a separation distance corresponding to a material thickness of the metal panel member interposed between the first refrigerant flow path and the press-fitting portion 130 adjacent to the LED unit 150.

In this case, the first refrigerant flow path 210 may be a portion in which liquid refrigerant of the refrigerant filled in the refrigerant flow space 205 is stored and retained, and may be arranged vertically in a gravitational direction. Therefore, the liquid refrigerant stored in the first refrigerant flow path 210 may have a liquid level positioned relatively lower in the gravitational direction in consideration of an increase in volume when it undergoes a phase change into gas refrigerant.

In addition, the "separation distance corresponding to the material thickness" may refer to a distance by which the first refrigerant flow path 210 is spaced apart from the LED unit 150 or the press-fitting portion 130.

Meanwhile, the second refrigerant flow path 220 may have its shape defined by a plurality of inclined guides 215 protruding toward the refrigerant flow space 205 to substantially prevent directly dropping of the condensed liquid refrigerant in a gravitational direction and to guide an inclined flow toward the first refrigerant flow path 210 by a property of surface tension of the liquid.

More specifically, when the refrigerant in a gas state (gas refrigerant) is aggregated into a refrigerant in a liquid state (liquid refrigerant) through a heat exchange process with outdoor air in the condensation region, the second refrigerant flow path 220 provides a flow path such that, as the volume gradually increases at a position in the refrigerant flow space 205 where aggregation occurs and the liquid flows downward in the gravitational direction, a uniform amount of liquid refrigerant flows toward and is supplied to the first refrigerant flow path 210.

In particular, as will be described later, the second refrigerant flow path 220 may be defined between the plurality of inclined guides 215. When the liquid refrigerant aggregated in the condensation region flows down toward the first refrigerant flow path 210, dispersed flow toward a second refrigerant flow path 220 adjacent to its own flow path, that is, the second refrigerant flow path 220 may be suppressed by surface tension.

That is, since flow spaces defined by the plurality of inclined guides 215 are narrower than the second refrigerant flow path 220, as will be described later, surface tension acts so that flow toward adjacent second refrigerant flow paths 220 is restrained.

As described above, when dispersed flow of the condensed liquid refrigerant is restrained by the plurality of inclined guides 215 and the second refrigerant flow paths 220, direct downward dropping of the liquid refrigerant in a gravitational direction may be minimized. Further, by lower ends respectively connected to the first refrigerant flow path 210 at uniform intervals, the liquid refrigerant aggregated in the condensation region may be supplied in a uniform amount toward the first refrigerant flow path 210 without being concentrated in a particular region.

In addition, the plurality of second refrigerant flow paths 220 may be defined between the plurality of inclined guides 215 protruding inward into the refrigerant flow space 205 from mutually facing surfaces of the one-side heat conduction panel 200-1 and the other-side heat conduction panel 200-2.

Here, the plurality of inclined guides 215 defining the second refrigerant flow paths 220 may be provided in a form protruding toward the refrigerant flow space 205 from respective inner surfaces of the one-side heat conduction panel 200-1 and the other-side heat conduction panel 200-2, as illustrated in FIGS. 9 and 12.

The plurality of inclined guides 215 may be provided in a straight-line form inclined downward in a gravitational direction toward the first refrigerant flow path 210. Thus, the liquid refrigerant condensed at the heat dissipation plate portion 203 side may naturally aggregate and then flow down toward the first refrigerant flow path 210 along spaces between the plurality of downwardly inclined guides 215, thereby serving to enhance a circulation speed of the liquid refrigerant.

Here, the plurality of second refrigerant flow paths 220 or the plurality of inclined guides 215 may be arranged such that adjacent second refrigerant flow paths 220 or inclined guides 215 are disposed parallel to each other. In general, liquid refrigerant condensed in a wide condensation region having a larger area than the evaporation region limited to the first refrigerant flow path 210 may have its flow distributed through the second refrigerant flow paths 220 or the inclined guides 215, which are densely and uniformly arranged in parallel, thereby providing an advantage in that heat is dissipated through the entire condensation region with uniform heat dissipation performance.

Further, the plurality of inclined guides 215 may be formed on each of the one-side heat conduction panel 200-1 and the other-side heat conduction panel 200-2, and tip portions thereof protruding toward the refrigerant flow space 205 may be formed so as not to be joined within the refrigerant flow space 205 but to be spaced apart from each other.

As described above, since the second refrigerant flow path 220 performs a function of guiding the flow of liquid refrigerant in a gravitational direction, it is preferable that the second refrigerant flow path 220 have a thickness-direction dimension that allows the flow to be naturally formed in the gravitational direction without being stopped by surface tension, which is an inherent property of liquid. In addition, the second refrigerant flow path 220 may be formed such that, after the liquid refrigerant aggregates to at least a predetermined size, dispersed flow toward an adjacent second refrigerant flow path 220 by surface tension or gravity is restrained.

Further, in the plurality of second refrigerant flow paths 220 or the plurality of inclined guides 215, at least one of opposite ends thereof may be connected to the evaporation region or to the first refrigerant flow path 210 formed in the evaporation region, and an end (i.e., one of the opposite ends) connected to the evaporation region or to the first refrigerant flow path 210 formed therein may be positioned lower in a gravitational direction than the other end.

Thus, when at least one of opposite ends of the plurality of second refrigerant flow paths 220 is defined as "one end," the one end may have the same meaning as a "lower end" positioned lower in a gravitational direction. Conversely, when the other of the opposite ends of the plurality of second refrigerant flow paths 220 is defined as "the other end," the other end may have the same meaning as an "upper end" positioned higher in the gravitational direction.

Furthermore, as described above, in the plurality of second refrigerant flow paths 220 or the plurality of inclined guides 215, at least one of the opposite ends may be connected to the first refrigerant flow path 210, and the opposite ends may be formed to be aligned in a straight line.

Such a straight-line configuration of the plurality of second refrigerant flow paths 220 may minimize a distance between one end at a side of the first refrigerant flow path 210, which is positioned closest to the heat-generating elements 140 and receives heat therefrom, and the other end at an outermost edge of the condensation region where condensation actively occurs through heat exchange with outside air, and the straight-line configuration of the second refrigerant flow paths 220 themselves may be recognized as an optimal shape capable of minimizing an overlapping length (flow resistance length) between a flow path of the liquid refrigerant and a flow path of the gas refrigerant.

That is, in the heat dissipation unit 200, the first refrigerant flow path 210 at a portion corresponding to the press-fitting end 201 of the refrigerant flow space 205 formed inside the one-side heat conduction panel 200-1 and the other-side heat conduction panel 200-2 is positioned close to the LED unit 150 or the press-fitting portion 130, and a straight-line structure and a gas-liquid flow separation structure are applied such that gas-liquid circulation from the first refrigerant flow path 210 (i.e., one end in the width direction) to an outer end of the condensation region (i.e., the other end in the width direction) is smoothly performed without substantial flow resistance.

Further, the second refrigerant flow paths 220 are formed such that a plurality thereof do not branch from the other end in the width direction toward the one end in the width direction, which corresponds to the first refrigerant flow path 210 positioned relatively lower in the gravitational direction, in order to guide liquid flow of the liquid refrigerant that has undergone the phase change from the gas refrigerant within the refrigerant flow space.

Meanwhile, as described above, the plurality of inclined guides 215 not only define the second refrigerant flow paths 220 between the respective inclined guides 215 as flow paths that guide the flow of liquid refrigerant in the gravitational direction, but may also perform a function of defining a third refrigerant flow path 230 to be described later, corresponding to a spaced portion in the thickness direction.

In this case, on the premise that the first refrigerant flow path 210 is positioned relatively lower in the gravitational direction due to tilting adjustment of the entire lighting body 110, it is preferable that the plurality of inclined guides 215 be patterned to be inclined with respect to the first refrigerant flow path 210 so as to form a flow path along which liquid refrigerant flows.

Here, the second refrigerant flow paths 220 defined as spaces between adjacent inclined guides 215 may be refrigerant flow paths extending upwardly and obliquely from the first refrigerant flow path 210 toward width-direction ends of the one-side heat conduction panel 200-1 and the other-side heat conduction panel 200-2, respectively. This is intended to allow the liquid refrigerant liquefied at the heat dissipation plate portion 203 side to be easily moved by its own weight toward the first refrigerant flow path 210 provided with the absorber 300.

Meanwhile, at portions corresponding to the condensation region of the one-side heat conduction panel 200-1 and the other-side heat conduction panel 200-2, a plurality of strength reinforcing portions 240 may be symmetrically formed to protrude into the refrigerant flow space 205.

When the one-side heat conduction panel 200-1 and the other-side heat conduction panel 200-2 are mutually joined by a bending or joining method, the plurality of strength reinforcing portions 240 may have their mutually contacting portions within the refrigerant flow space 205 joined through a joining process using various coupling methods, including a laser welding method, thereby serving to reinforce the overall strength of the heat dissipation unit 200.

In addition, the plurality of strength reinforcing portions 240 may also serve to promote active condensation by providing a larger interference area against which the gas refrigerant, vaporized for heat dissipation in the condensation region, impinges. That is, the plurality of strength reinforcing portions 240 further increase the contact surface area with the gas refrigerant flowing freely through the third refrigerant flow path 230, which will be described later, thereby enabling the refrigerant to condense within a shorter period of time.

In addition, the heat dissipation unit 200 may further include the third refrigerant flow path 230, which serves as a flow path for the gas refrigerant other than the liquid refrigerant mainly flowing along the plurality of inclined guides 215, as described with reference to FIGS. 9 to 12.

Here, referring to FIG. 12, the second refrigerant flow path 220 is formed in each of the one-side heat conduction panel 200-1 and the other-side heat conduction panel 200-2, and is defined as being formed between adjacent ones of the plurality of inclined guides 215, excluding the thickness direction of the refrigerant flow space 205. In contrast, the third refrigerant flow path 230 may be defined, in the thickness direction of the refrigerant flow space 205, as a space between the inclined guide 215 formed on the one-side heat conduction panel 200-1 and the inclined guide 215 formed on the other-side heat conduction panel 200-2.

However, when defining the second refrigerant flow path 220, the expression "excluding the thickness direction" means that the reference direction for the definition is not the thickness direction, and it should not be construed as excluding the volume occupied by the thickness direction as a corresponding volume or space.

More specifically, the third refrigerant flow path 230 may be defined in a case where the inclined guides 215 protrude further into the refrigerant flow space 205 than the second refrigerant flow path 220, such that a thickness dimension of the refrigerant flow space 205 is set to be smaller than that of the second refrigerant flow path 220. That is, the third refrigerant flow path 230 may be defined as a region having a smaller thickness than the second refrigerant flow path 220, as defined by the plurality of inclined guides 215.

In addition, the third refrigerant flow path 230 may be defined as a portion, among opposing surfaces of the one-side heat conduction panel 200-1 and the other-side heat conduction panel 200-2 of the heat conduction panel bodies 200-1 and 200-2, where the plurality of inclined guides 215 are formed and which is not joined within the refrigerant flow space 205 but remains spaced apart from each other.

The third refrigerant flow path 230 may serve to provide a gas flow path to allow the refrigerant filled in the refrigerant flow space 205, after undergoing the phase change into the gas refrigerant in the evaporation region which is the first refrigerant flow path 210, to be easily diffused and flow throughout the entire heat dissipation plate portion 203. The gas refrigerant evaporated in the first refrigerant flow path 210, which is the evaporation region, may move toward the heat dissipation plate portion 203 and be smoothly and uniformly dispersed through the third refrigerant flow path 230 to perform heat dissipation while being condensed.

For example, when the liquid refrigerant naturally flows downward through the space between adjacent inclined guides 215 adjacent to the second refrigerant flow path 220, the gas refrigerant actively flows through the third refrigerant flow path 230, which is a space not occupied by the liquid refrigerant.

However, this does not mean that the liquid refrigerant is completely separated from the gas refrigerant and does not occupy the third refrigerant flow path 230. Rather, it is preferable to understand that the gas refrigerant flows more actively through the third refrigerant flow path 230.

That is, since the phase change of the refrigerant does not occur with the liquid refrigerant and the gas refrigerant being completely separated, it is difficult to define them with precise distinction. However, in general, the second refrigerant flow path 220, having a relatively larger dimension in the thickness direction, may serve as a path through which the liquid refrigerant mainly flows, while the third refrigerant flow path 230 may serve as a path through which the gas refrigerant mainly flows.

More specifically, because the gas refrigerant is more active than the liquid refrigerant, the third refrigerant flow path 230, having a relatively smaller dimension in the thickness direction, may serve as the main flow path for the gas refrigerant. In contrast, considering the surface tension of the liquid refrigerant itself, the second refrigerant flow path 220, having a larger dimension in the thickness direction than the third refrigerant flow path 230, may serve as the main flow path for the liquid refrigerant.

Meanwhile, the third refrigerant flow path 230 may also be defined as a refrigerant flow path that connects spaces between the second refrigerant flow paths 220, which are spaced apart from each other in parallel.

For example, each of the second refrigerant flow paths 220 may have a predetermined pattern shape, the second refrigerant flow path being processed to protrude from portions of the one-side heat conduction panel 200-1 and the other-side heat conduction panel 200-2 where the refrigerant flow space 205 is formed, and being partitioned by the third refrigerant flow path 230, which is formed so as not to be in surface contact within the refrigerant flow space 205. It should be noted that the term "partitioned" as used herein does not mean a physically and spatially complete partition, but rather refers to a distinction in shape and position between the second refrigerant flow path 220 and the third refrigerant flow path 230.

In the lighting apparatus 100 according to an embodiment of the present disclosure having the above-described configuration, the heat dissipation unit 200 is configured such that the liquid refrigerant condensed in the condensation region other than the evaporation region flows downward in the direction of gravity along the plurality of inclined guides 215 defining the second refrigerant flow path 220, and the gas refrigerant evaporated in the evaporation region flows in a gas state between the plurality of inclined guides 215 defining the third refrigerant flow path 230.

Meanwhile, in the evaporation region corresponding to the first refrigerant flow path 210, an absorber 300 may be further installed to absorb the liquid refrigerant and to promote active vaporization of the absorbed liquid refrigerant by heat supplied from the LED unit 150.

That is, the absorber 300 may be disposed on the first refrigerant flow path 210 positioned close to the LED unit 150 or the press-fitting portion 130, which is a heat dissipation target, and may serve to raise at least the liquid refrigerant of the refrigerant upward beyond its absorption point by capillary force or absorption force.

To this end, the absorber 300 may be made of a fibrous material such as a nonwoven fabric having a plurality of pores formed therein. In addition, since it is disposed on the first refrigerant flow path 210 extending vertically, it is preferably formed of a material capable of dispersing and transporting the liquid refrigerant by capillary action (or inherent absorption force) against gravity (i.e., in a direction opposite to gravity) over at least a predetermined height in the vertical direction.

More specifically, the absorber 300 may include any one of a nonwoven fabric forming a plurality of pores (a kind of wick structure), a nonwoven fabric supported by a metal wire or a metal braided body, and a metal sintered body formed by sintering metal powder.

The metal material here may include copper having excellent thermal conductivity, and the nonwoven fabric may be supported by a thin metal wire made of copper or by a copper wire braided body formed by braiding such metal wires.

That is, the absorber 300 may be adopted as a nonwoven fabric itself made of a fibrous material. In this case, since the nonwoven fabric is inherently very flexible and may have difficulty maintaining its shape in the vertical direction due to the weight of the absorbed liquid refrigerant when the liquid refrigerant is absorbed, the nonwoven fabric may be provided to be supported by a copper wire or by a braided body made of copper wire braided together.

Here, the nonwoven fabric may be configured to be inserted into the braided body made of copper wire so that its shape is maintained. Thus, the nonwoven fabric provided as the absorber 300 may be stably fixed and prevented from moving on the first refrigerant flow path 210 arranged in the direction of gravity (i.e., the vertical direction) or inclined with respect to the direction of gravity.

However, it is not necessarily required that the nonwoven fabric be supported by being inserted into the interior of the braided body made of copper wire. Rather, it is also possible to adopt a support configuration in which a single strand of copper wire penetrates the nonwoven fabric in the vertical direction, or in which the copper wire spirally surrounds the nonwoven fabric.

In addition, as long as the absorber 300 may maintain its shape despite the load of the retained liquid refrigerant, the nonwoven fabric may be coupled to the interior of the braided body made of copper wire. Alternatively, the copper wire itself or the braided body made of copper wire may be provided to spirally surround an outer circumferential surface of the nonwoven fabric.

Meanwhile, in the heat dissipation unit 200, when the first refrigerant flow path 210 is formed to be very long in the vertical direction, at least one auxiliary absorber 301 may be further provided in a portion of the second refrigerant flow path 220 at an upper side of the refrigerant flow space 205.

The auxiliary absorber 301 may be seated and installed in an auxiliary absorber installation portion (not shown in the drawings), which is formed by modifying and processing a part of the second refrigerant flow path 220 to have a relatively larger width.

As shown in FIG. 10, two auxiliary absorbers 301-1 and 301-2 of the auxiliary absorber 301 may be arranged to be vertically spaced apart from each other at a relatively upper side in the direction of gravity.

Meanwhile, as shown in FIGS. 8 to 11, the heat dissipation unit 200 may further include an air vent tube 270 at an end forming the heat dissipation plate portion 203, the air vent tube being configured to evacuate the refrigerant flow space 205 before or after the refrigerant is injected into the refrigerant flow space 205.

When the evacuation of the refrigerant flow space 205 described above is completed, the air vent tube 270 may be cut by a cutter (not shown) and then sealed through a predetermined caulking process. Alternatively, after completing the caulking process without cutting, the air vent tube 270 may be inserted into the seating groove 505 formed in the lower horizontal support bar 500DB among the components of the finger guard panel assembly 500 described above, thereby being protected from the outside.

In addition, the one-side heat conduction panel 200-1 and the other-side heat conduction panel 200-2 constituting the heat dissipation unit 200 may be provided in the form of plates made of SUS (stainless steel) among metal panel members, as described above. Accordingly, unlike a case in which the metal panel member is made of aluminum, the refrigerant filled therein may be water.

This is because, when the metal panel member of the heat dissipation unit 200 is made of aluminum, aluminum has a chemical property of being converted into aluminum oxide while generating hydrogen while it comes into contact with water, so that water is excluded from the types of refrigerants that may be employed.

The heat dissipation unit 200 made of aluminum is expected to exhibit much higher heat dissipation performance than one made of SUS in terms of the intrinsic thermal conductivity of the material itself. However, in the lighting apparatus 100 according to an embodiment of the present disclosure, the heat dissipation unit 200 is provided as a metal panel member made of SUS and employs a heat transfer method using a phase change material (in particular, water) that may be filled in the refrigerant flow space 205, thereby achieving a remarkable improvement in heat dissipation performance. Accordingly, unlike the conventional lighting apparatus (see the Background Art), there is no need for an additional heat dissipation structure to address concentrated heat generation at a central portion, and sufficient heat dissipation may be achieved solely by the heat dissipation unit 200 according to an embodiment of the present disclosure, which is vertically arranged in the up-down direction.

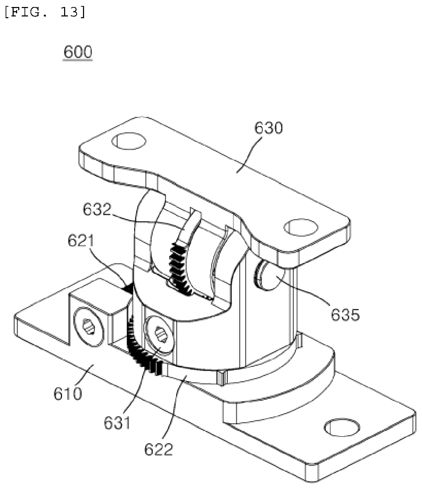

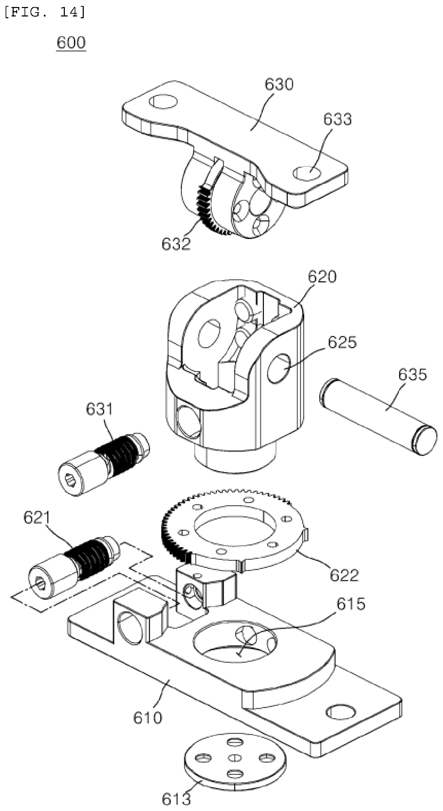

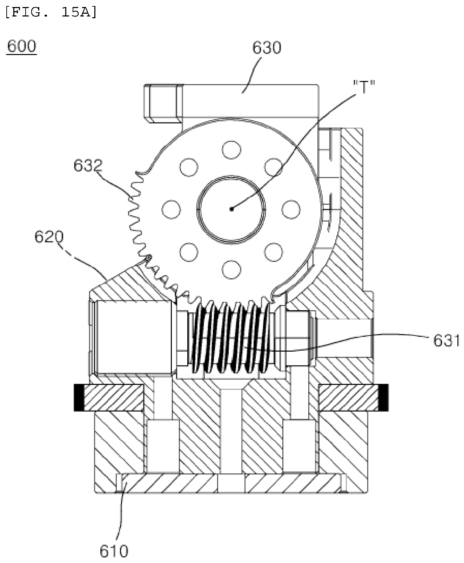

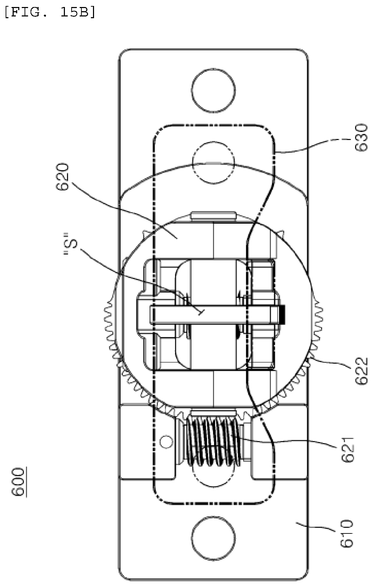

FIG. 13 is a perspective view illustrating one implementation of an angle adjustment unit among components of the lighting apparatus according to an embodiment of the present disclosure, FIG. 14 is an exploded perspective view of FIG. 13, and FIGS. 15A and 15B are partial perspective views for explaining an operation of the angle adjustment unit by tilting rotation and steering rotation.

Referring to FIGS. 13 to 15B, the lighting apparatus 100 according to an embodiment of the present disclosure may further include the angle adjustment unit 600 disposed at a lower end of the lighting body 110 and configured to adjust an irradiation direction of the LED unit 150.

As shown in FIGS. 13 and 14, the angle adjustment unit 600 may include a fixing bracket 610 configured to fix the lighting body 110 at a predetermined position, a steering block 620 configured to steer and rotate left and right about a vertical axis S with respect to the fixing bracket 610, and a tilting block 630 configured to tilt and rotate forward and backward with respect to the steering block 620 about a horizontal left-right coupling shaft 635 or T, with a lower end of the lighting body 110 being connected thereto.

Here, the steering block 620 may be coupled to the fixing bracket 610 so as to be rotatable via a fixing panel 613 coupled to a lower portion of the fixing bracket 610 in a state in which a lower end of the steering block 620 is inserted into an installation hole 615 formed to vertically penetrate the fixing bracket 610.

The steering block 620 may be provided with a steering worm wheel gear 622 having a plurality of worm wheel gear teeth (no reference numeral assigned) formed on a portion of its outer circumferential surface. The fixing bracket 610 may be rotatably provided with a steering worm gear 621 having worm gear teeth (no reference numeral assigned) formed to engage with the worm wheel gear teeth of the steering worm wheel gear 622, such that the steering worm gear may engage with the steering worm wheel gear 622.

Here, the lighting body 110 is configured such that the steering block 620 is steered and rotated in the left-right direction according to the axial rotation of the steering worm gear 621, thereby allowing the irradiation direction of the LED unit 150 to be adjusted.

In addition, the steering block 620 may be formed with a left-right horizontal shaft coupling hole 625 penetrating therethrough in the left-right direction, and a lower end of the tilting block 630 may be tiltably coupled by the left-right horizontal coupling shaft 635 passing through the left-right horizontal shaft coupling hole 625.

Further, the steering block 620 may be rotatably provided with a tilting worm wheel gear 632 having a plurality of worm wheel gear teeth (no reference numeral assigned) formed on a portion of its outer circumferential surface. A tilting worm gear 631 having worm gear teeth (no reference numeral assigned) engageable with the worm wheel gear teeth of the tilting worm wheel gear 632 may be rotatably provided at the lower end of the tilting block 630.

Here, the lighting body 110 is configured such that the tilting block 630 is tilted and rotated in the forward and backward direction according to the axial rotation of the tilting worm gear 631, thereby allowing the irradiation direction of the LED unit 150 to be adjusted.

The tilting block 630 may be formed with a bolt fastening hole 633 for bolt connection with the lower end of the lighting body 110.

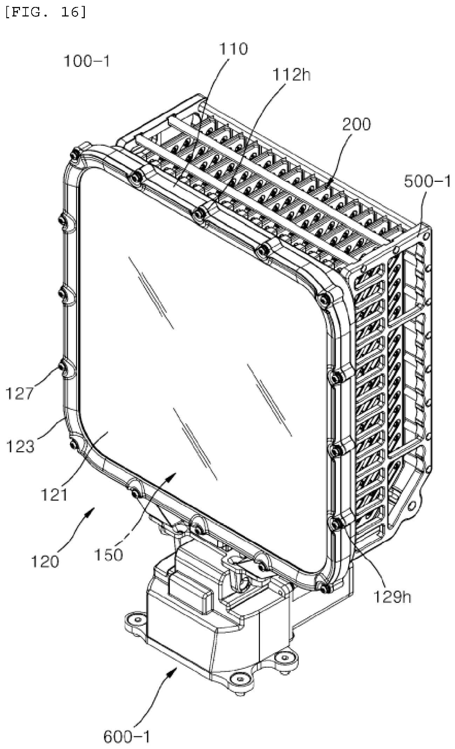

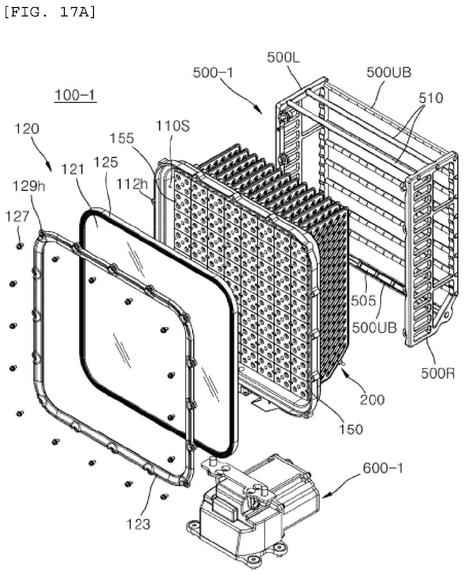

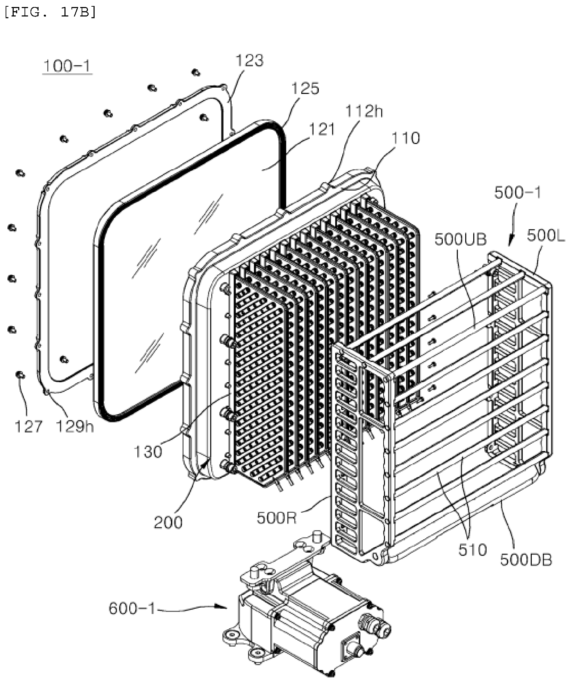

FIG. 16 is a perspective view illustrating a lighting apparatus according to another embodiment of the present disclosure, and FIGS. 17A and 17B are front and rear exploded perspective views for explaining a finger guard panel assembly among components of FIG. 16.

A lighting apparatus 100-1 according to another embodiment of the present disclosure, as shown in FIGS. 16 to 17B, may include a finger guard panel assembly 500-1 configured to protect the lighting body 110 and the heat dissipation unit 200 installed for heat dissipation thereof from the outside, in which the finger guard panel assembly may be implemented in a different manner from the finger guard panel assembly 500 shown in FIGS. 2A to 5.

That is, the finger guard panel assembly 500 implemented according to an implementation as shown in FIGS. 2A to 5 is entirely provided in a panel form, whereas the finger guard panel assembly 500-1 implemented according to another implementation as shown in FIGS. 16 to 17B may be modified such that a part of the configuration is replaced with support pipes 510.

More specifically, the finger guard panel assembly 500 according to another implementation may include, as shown in FIGS. 17A and 17B, a left finger guard panel 500L covering a left side of the plurality of heat dissipation units 200, a right finger guard panel 500R covering a right side of the plurality of heat dissipation units 200, a lower horizontal support bar 500DB connected to and supporting lower ends of the right finger guard panel 500R and the rear finger guard panel 500P, and an upper horizontal support bar 500UB connected to and supporting upper ends of the left finger guard panel 500L, the right finger guard panel 500R, and the rear finger guard panel 500P.

Here, among the components of the finger guard panel assembly 500-1 according to another implementation, the left finger guard panel 500L and the right finger guard panel 500R are implemented in the same panel form as the left finger guard panel 500L and the right finger guard panel 500R of the finger guard panel assembly 500 according to the above-described implementation. In addition, the lower horizontal support bar 500DB and the upper horizontal support bar 500UB similarly connect and support the lower and upper ends of the left finger guard panel 500L and the lower and upper ends of the right finger guard panel 500R in the left-right horizontal direction.

However, the finger guard panel assembly 500-1 according to another implementation does not separately include the upper finger guard panel 500T and the rear finger guard panel 500P among the components of the finger guard panel assembly 500 of the above-described implementation. Instead, it may further include a plurality of support pipes 510 arranged horizontally in the left-right direction. The plurality of support pipes 510 may be coupled to the upper ends of the left finger guard panel 500L and the right finger guard panel 500R at at least two positions spaced apart from each other in the front-rear direction, and may also be coupled to rear ends of the left finger guard panel 500L and the right finger guard panel 500R at a plurality of positions spaced apart from each other in the vertical direction.

Here as well, it should be understood that the lower horizontal support bar 500DB may be formed with a seating groove 505 extending in the left-right direction to accommodate the air vent tube 270 among the components of the heat dissipation unit 200.

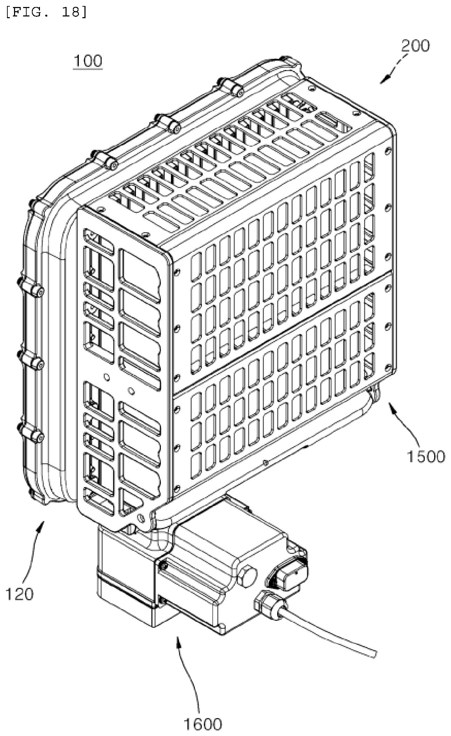

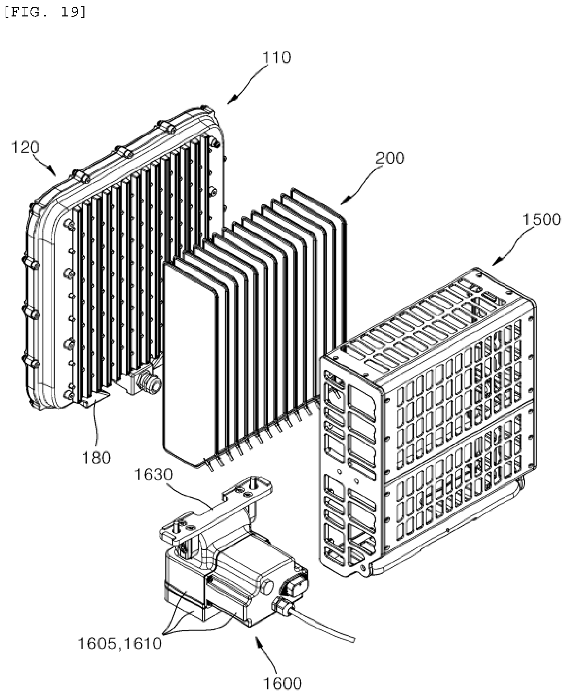

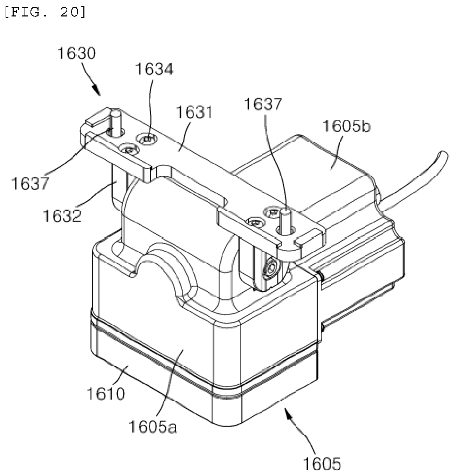

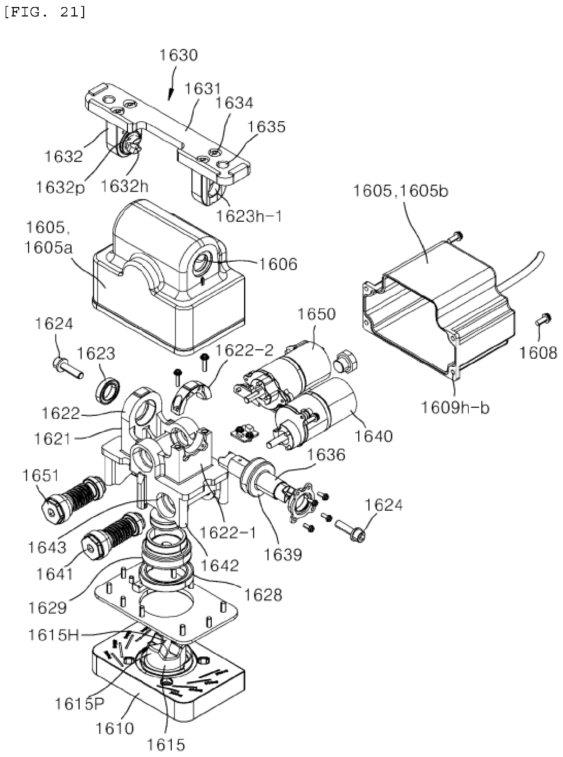

FIG. 18 is a rear perspective view illustrating a state in which another implementation of the angle adjustment unit is installed in the configuration of the lighting apparatus according to an embodiment of the present disclosure, FIG. 19 is an exploded perspective view of FIG. 18, FIG. 20 is a perspective view illustrating another implementation of the angle adjustment unit among the components of the lighting apparatus according to an embodiment of the present disclosure, and FIG. 21 is an exploded perspective view of FIG. 20.

Referring to FIGS. 18 to 21, in the lighting apparatus 100 according to an embodiment of the present disclosure, an angle adjustment unit 1600 may be embodied as another implementation.

While the angle adjustment unit 600 according to the above-described implementation allows a user to manually adjust the irradiation direction of the LED unit 150 provided in the lighting body 110, the angle adjustment unit 1600 according to another implementation is disposed at a lower end of the lighting body 110, as illustrated in FIGS. 18 and 19, and is configured to automatically and remotely adjust the irradiation direction of the LED unit 150 provided in the lighting body 110 by a steering drive motor 1640 and a tilting drive motor 1650, which will be described later, that are electrically operated.

More specifically, as illustrated in FIGS. 20 and 21, the angle adjustment unit 1600 according to another implementation may include a steering part 1620 configured to adjust the irradiation direction of the LED unit 150 in a left-right horizontal direction, and a tilting part 1630 configured to adjust the irradiation direction of the LED unit 150 in an up-down vertical direction.

Here, the angle adjustment unit 1600 according to another implementation may further include a housing part 1605 configured to cover and shield at least a portion of the steering part 1620 and the tilting part 1630.

The housing part 1605 may include a housing base panel part 1610 configured to primarily support the steering part 1620 among the steering part 1620 and the tilting part 1630 and to mediate installation at a place where lighting is required, a front housing 1605a disposed to cover the steering part 1620 and the tilting part 1630 from a front side, and a rear housing 1605b disposed to cover the steering part 1620 and the tilting part 1630 from a rear side.

As illustrated in FIG. 21, the front housing 1605a may be coupled to an upper surface of the housing base panel part 1610 so as to cover components disposed on an upper portion of the housing base panel part 1610, the components corresponding to remaining portions of the steering part 1620 and the tilting part 1630 except for a steering drive motor 1640 and a tilting drive motor 1650, which will be described later.

As illustrated in FIG. 21, the rear housing 1605b may be coupled to one side surface of the front housing 1605a so as to cover the steering drive motor 1640 and the tilting drive motor 1650, which will be described later, among the components of the steering part 1620 and the tilting part 1630, or to provide coupling portions therefor.

Here, a front screw fastening hole (not shown) and a rear end screw fastening hole 1609h-b for screw coupling using a housing assembly screw 1608 may be formed at mutually facing ends of the front housing 1605a and the rear housing 1605b.

The front housing 1605a and the rear housing 1605b may be provided to be steerably rotatable in a left-right direction about a steering shaft groove (not shown) or a steering shaft boss 1615, which will be described later, on an upper portion of the housing base panel part 1610.

Meanwhile, as illustrated in FIG. 21, the steering shaft boss 1615 may be provided at a central portion of the upper surface of the housing base panel part 1610. The steering shaft boss 1615 may be formed to protrude upward from the housing base panel part 1610, and may include a corresponding stopping protrusion 1615P and a corresponding stopping groove 1615H that are respectively fitted with a stopping protrusion (not shown) and a stopping groove (not shown) of a steering worm wheel gear part 1629, which will be described later.

As illustrated in FIG. 21, the steering part 1620 may include a steering base panel 1621 to which an upper end of a steering shaft 1626 is bolted and which is steered and rotated in conjunction with axial rotation of the steering shaft 1626, a steering worm gear part 1641 horizontally disposed at one lower side of the steering base panel 1621 and configured to rotate about its axis, and a steering worm wheel gear part 1629 interposed on an outer circumferential surface of the steering shaft 1626 and fixed so as not to rotate with respect to the housing base panel part 1610.

A plurality of worm wheel gear teeth may be formed on an outer circumferential surface of the steering worm wheel gear part 1629, and at least one stopping protrusion and stopping groove may be formed on a lower surface of the steering worm wheel gear part 1629 so that the steering worm wheel gear part may be fixed without rotating with respect to the housing base panel part 1610.

The steering worm gear part 1641 may be rotatably provided via a worm gear installation bracket 1642 coupled to a lower portion of the steering base panel 1621.

Here, worm wheel gear teeth (not shown) engaged with worm gear teeth of the steering worm gear part 1641 may be formed on a portion of an outer circumferential surface of the steering worm wheel gear part 1629. In addition, the steering part 1620 may further include a wheel bearing part 1628 interposed between the outer circumferential surface of the steering worm wheel gear part 1629 and the steering base panel 1621.

An inner race of the wheel bearing part 1628 may be press-fitted and fixed to a remaining portion of the outer circumferential surface of the steering worm wheel gear part 1629 where the worm wheel gear teeth are not formed, and an outer race of the wheel bearing part 1628 may be press-fitted and fixed to the steering base panel 1621, thereby rotatably supporting steering rotation of the steering base panel 1621 about the steering worm wheel gear part 1629 as a rotation center.

Meanwhile, as illustrated in FIG. 21, the steering part 1620 may further include a steering drive motor 1640 directly connected to one of both ends of the steering worm gear part 1641 and coupled to one side surface of the front housing 1605a.

Here, a motor shaft (not shown) of the steering drive motor 1640 may pass through one side surface of the front housing 1605a and be directly connected to one end of the steering worm gear part 1641 provided inside the front housing 1605a.

As illustrated in FIG. 21, the tilting part 1630 may include a tilting shaft 1636 provided horizontally with respect to an upper surface of the steering base panel 1621, and a tilting bracket panel 1631 which is configured to be tilted and rotated in an up-down direction or a front-rear direction about the tilting shaft 1636 and to which a lower end of the lighting body 110 among the components of the lighting apparatus 100 according to an embodiment of the present disclosure is fixed.

A pair of vertical mounting panels 1622 may be disposed on the upper surface of the steering base panel 1621 to be spaced apart from each other by a predetermined distance in a left-right direction, and each of the pair of vertical mounting panels 1622 may be formed with a tilting shaft installation hole (reference numeral not indicated) in which the tilting shaft 1636 is installed to be rotatably supported through a rotation support bearing part 1623.

Here, one of the pair of vertical mounting panels 1622 may be provided as an integral mounting panel 1622-1 formed integrally with the steering base panel 1621 and a detachable mounting panel 1622-2 detachably coupled to the integral mounting panel 1622-1. With the detachable mounting panel 1622-2 separated from the integral mounting panel 1622-1, the tilting shaft 1636 may be installed in a stable and convenient manner by first seating one end of the tilting shaft 1636 on the integral mounting panel 1622-1 and then coupling the detachable mounting panel 1622-2 to the integral mounting panel 1622-1.

In addition, as illustrated in FIG. 21, the tilting part 1630 may further include a tilting worm wheel gear part 1639 integrally formed on an outer circumferential surface of the tilting shaft 1636 and having worm wheel gear teeth (not shown) formed on an outer circumferential surface thereof, and a tilting worm gear part 1651 having worm gear teeth (not shown) formed on an outer circumferential surface thereof to be engaged with the worm wheel gear teeth of the tilting worm wheel gear part 1639.

Here, the tilting worm gear part 1651, like the steering worm gear part 1641, may also be fixed to the upper surface of the steering base panel 1621 through a worm gear installation bracket (reference numeral not indicated). Thus, when the steering base panel 1621 is steered and rotated, the tilting worm gear part 1651 may also be steered and rotated in conjunction therewith.

At this time, the tilting worm gear part 1651 may be elongated in a front-rear horizontal direction and disposed between the pair of vertical mounting panels 1622, and the tilting worm wheel gear part 1639 integrally formed on the outer circumferential surface of the tilting shaft 1636 may be disposed relatively above the tilting worm gear part 1651.

Meanwhile, as illustrated in FIG. 21, a pair of tilting mounting panels 1632, which mediate coupling to respective outer side surfaces of the pair of vertical mounting panels 1622, may be vertically coupled to a lower surface of the tilting bracket panel 1631.

In the tilting bracket panel 1631, panel screw through-holes (reference numerals not indicated) for fastening the pair of tilting mounting panels 1632 using at least two fastening members 1634 may be formed to vertically penetrate therethrough. In addition, the tilting bracket panel 1631 may be formed with a bolt through-hole 1635 vertically penetrating therethrough, through which a fixing bolt 1637 for fixed installation to a lower portion of the lighting body 110 passes.

Meanwhile, both ends of the tilting shaft 1636 may respectively pass through the tilting shaft installation holes of the pair of vertical mounting panels 1622 and be exposed to the outside.

Here, at both ends of the tilting shaft 1636 exposed to the outside through the tilting shaft installation holes, at least one fitting protrusion (not shown) forming both end surfaces thereof and at least one fitting groove (not shown) recessed inward from both end surfaces of the tilting shaft 1636 may be formed.

In addition, corresponding fitting protrusions 1632P and corresponding fitting grooves 1632H, which are respectively fitted with the fitting protrusions and the fitting grooves formed at both ends of the tilting shaft 1636, may be formed on inner surfaces, facing the tilting shaft installation holes, among both surfaces of the pair of tilting mounting panels 1632.

As described above, the corresponding fitting protrusions 1632P and the corresponding fitting grooves 1632H of the pair of tilting mounting panels 1632 are coupled to be fitted with the fitting protrusions and the fitting grooves formed at both ends of the tilting shaft 1636, respectively. Thus, when the tilting shaft 1636 rotates about its axis, the pair of tilting mounting panels 1632 and the tilting bracket panel 1631 may be tilted and rotated in a front-rear direction (or an up-down direction) with respect to the tilting shaft 1636, thereby enabling tilting adjustment of the irradiation direction of the lighting apparatus 100 according to an embodiment of the present disclosure.

Here, the tilting bracket panel 1631 and the pair of tilting mounting panels 1632 may be installed to be exposed to the outside of the front housing 1605a so as to be coupled to both ends of the tilting shaft 1636 through outer tilting shaft installation holes 1606 formed at both sides of an upper end of the front housing 1605a to penetrate between the inside and the outside thereof.

Meanwhile, as illustrated in FIG. 21, the tilting part 1630 may further include a tilting drive motor 1650 having a motor shaft (reference numeral not indicated) directly connected to one of both ends of the tilting worm gear part 1651.

Here, the motor shaft of the tilting drive motor 1650 may pass through one side surface of the front housing 1605a and be directly connected to one end of the tilting worm gear part 1651 provided inside the front housing 1605a.

The tilting part 1630 configured as described above may operate such that, when a user applies power to the tilting drive motor 1650 and inputs a predetermined signal, the tilting drive motor 1650 is driven to rotate the motor shaft in one direction or the other direction. Thus, the tilting worm gear part 1651 having worm gear teeth engaged with the worm wheel gear teeth of the tilting worm wheel gear part 1639 integrally formed with the tilting shaft 1636 rotates about its axis, thereby allowing the tilting bracket panel 1631 to be tilted and rotated in a front-rear direction (or an up-down direction).

As described above, since the steering drive motor 1640 and the tilting drive motor 1650 are configured such that their motor shafts are electrically rotated, they provide an advantage in that the irradiation direction may be automatically adjusted remotely, compared to a conventional method in which an operator (or installer) manually adjusts the irradiation direction.

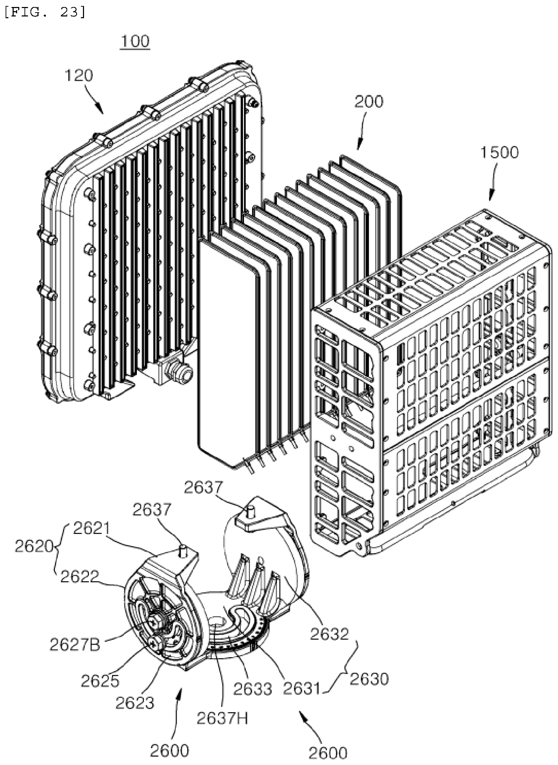

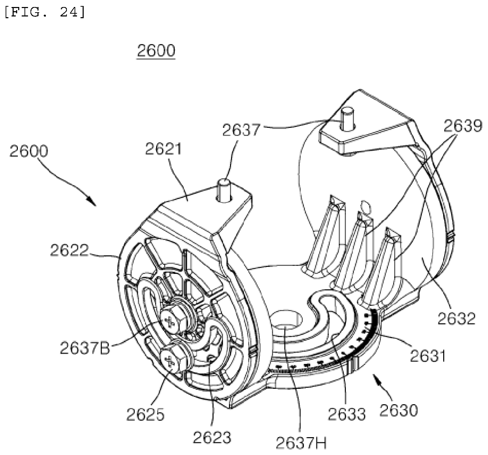

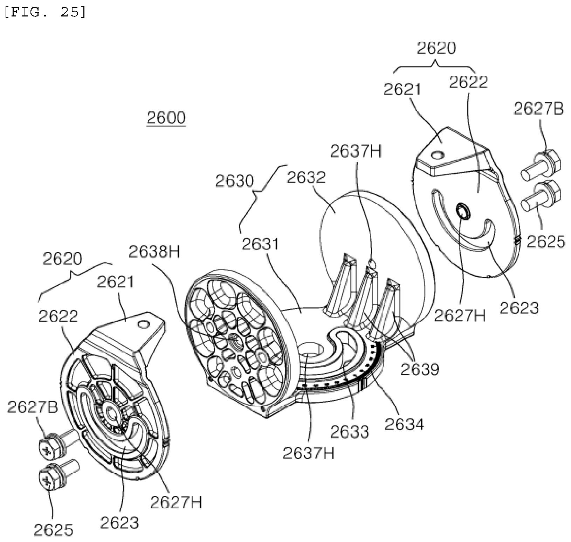

FIG. 22 is a rear perspective view illustrating a state in which still another implementation of the angle adjustment unit is installed in the configuration of the lighting apparatus according to an embodiment of the present disclosure, FIG. 23 is an exploded perspective view of FIG. 22, FIG. 24 is a perspective view illustrating still another implementation of the angle adjustment unit among the components of the lighting apparatus according to an embodiment of the present disclosure, and FIG. 25 is an exploded perspective view of FIG. 24.

Referring to FIGS. 22 to 25, in the lighting apparatus 100 according to an embodiment of the present disclosure, an angle adjustment unit 2600 may be embodied as still another implementation.

As illustrated in FIGS. 22 to 25, the angle adjustment unit 2600 according to still another implementation includes a tilting rotation panel part 2620 and a steering rotation panel part 2630.

The tilting rotation panel part 2620 may be fixed to the lighting body 110 and may be provided to be tilted and rotated in a front-rear direction about any left-right horizontal axis 2601 provided by the steering rotation panel part 2630 in conjunction with the lighting body 110.

More specifically, the tilting rotation panel part 2620 may include a tilting fixing panel 2621 coupled to a pair of mounting panel ends 180 provided at a lower portion (or an upper portion) of the lighting body 110 to be spaced apart from each other in a left-right direction, and a tilting rotation panel 2622 formed to be bent at a predetermined angle with respect to the tilting fixing panel 2621.

Here, the tilting fixing panel 2621 and the tilting rotation panel 2622 may each be provided as a pair and may be coupled to a pair of steering rotation panels 2632, which are provided as components of a steering rotation panel part 2630 to be described later, so as to be tiltable in a front-rear direction.

A fixing bolt 2637 may pass through the tilting fixing panel 2621 and be fastened to the mounting panel end 180 of the lighting body 110.

In addition, the pair of tilting rotation panels 2622 may be bent to be perpendicular to outer ends of the tilting fixing panels 2621. However, the bending angle between the tilting rotation panel 2622 and the tilting fixing panel 2621 does not necessarily have to be perpendicular, and may be formed at any angle as long as they are bent at an angle matching a corresponding surface of a steering rotation panel 2632 among the components of the steering rotation panel part 2630, which will be described later.

The steering rotation panel part 2630 may include a steering fixing panel 2631 coupled to an installation portion (not shown) of a place where the lighting apparatus 100 according to an embodiment of the present disclosure is installed, and a pair of steering rotation panels 2632 formed to be bent at a predetermined angle with respect to the steering fixing panel 2631.

The pair of steering rotation panels 2632 may be formed to be bent perpendicular to outer ends of the steering fixing panel 2631 and may be disposed to be in surface contact with respective inner surfaces of the pair of tilting rotation panels 2622 of the tilting rotation panel part 2620.

Referring to FIG. 24, the steering fixing panel 2631 and the pair of steering rotation panels 2632 may be integrally manufactured by a molding method, and a plurality of strength reinforcing ribs 2639 may be integrally formed at respective connection portions between the steering fixing panel 2631 and the pair of steering rotation panels 2632, thereby reinforcing the overall strength of the angle adjustment unit 2600.

Meanwhile, a steering fastening hole 2637H, which penetrates a central portion of the steering fixing panel 2631 in an up-down direction and to which a steering hinge bolt (not shown) for the installation portion is fixed, may be formed in the central portion of the steering fixing panel. In addition, the steering fixing panel 2631 may further include a steering guide slot 2633 cut within the range of the same rotational trajectory while being spaced apart from the steering fastening hole 2637H by a predetermined distance in a radial direction.

The steering rotation panel part 2630 allows the irradiation direction of the LED unit 150 to be adjusted to an angle desired by a user by adjusting a steering rotation angle while a steering guide bolt (not shown) is inserted into the steering guide slot 2633 in a state where the steering hinge bolt is hinge-coupled to the steering fastening hole 2637H and is freely rotatable, and then tightening the steering guide bolt. Here, angle indication graduations 2633 may be printed around the steering guide slot 2633 of the steering fixing panel 2631, allowing the user to visually estimate the steering angle of the lighting apparatus 100.

In addition, a tilting fastening hole 2627H may be formed at a central portion of each of the pair of tilting rotation panels 2622 so as to penetrate in a front-rear direction, and a tilting hinge bolt 2627B may pass through and be fastened to the tilting fastening hole 2627H at a central portion of each of the pair of steering rotation panels 2632. Furthermore, each of the pair of tilting rotation panels 2622 may further include a tilting guide slot 2623 cut within the range of the same rotational trajectory while being spaced apart from the tilting fastening hole 2627H by a predetermined distance in a radial direction.

The pair of tilting rotation panels 2622 allow the irradiation direction of the LED unit 150 to be adjusted to an angle desired by a user by adjusting a tilting rotation angle while the tilting guide bolt 2625 is inserted into the tilting guide slot 2623 in a state where the tilting rotation panels are freely rotatable with respect to the steering rotation panels 2632 to which the tilting hinge bolts 2627B are fastened through the tilting fastening holes 2627H, and then tightening the tilting guide bolt 2625. Here, although not illustrated, it is obvious that a configuration corresponding to the above-described angle indication graduations 2633 may be printed on the pair of tilting rotation panels 2622.

The angle adjustment unit 2600 according to still another implementation configured as described above is similar to the angle adjustment unit 600 according to the one implementation in that a user manually adjusts the irradiation direction of the LED unit 150, and is different from the angle adjustment unit 1600 according to the other implementation in that the irradiation direction of the LED unit 150 is automatically adjusted. However, the angle adjustment unit 2600 according to still another implementation not only has a very simple structure but also provides an advantage when a user manually adjusts an angle in a case where the lighting apparatus 100, which has a relatively heavy weight, is positioned below the angle adjustment unit 2600.

In the lighting apparatus 100 according to an embodiment of the present disclosure having the above-described configuration, concentration of heat generated from the LED unit 150 at a central portion may be alleviated, and effective heat dissipation may be achieved without modifying the structure through the heat dissipation unit 200 including the plurality of heat-conduction panel bodies 200 made of SUS and employing a refrigerant phase-change method that maximizes heat dissipation efficiency.

As described above, a lighting apparatus according to embodiments of the present disclosure has been described in detail with reference to the accompanying drawings. However, embodiments of the present disclosure are not necessarily limited to the above-described embodiments, and it will be apparent that various modifications and equivalent implementations are possible by those skilled in the art. Therefore, the true scope of the present disclosure is defined by the claims set forth below.

### [Industrial Applicability]

The present disclosure provides a lighting apparatus capable of maximizing heat dissipation performance by including a heat dissipation unit that can effectively dissipate heat generated from an LED unit.

## Claims

1. A lighting apparatus comprising:
an LED unit configured to generate and emit predetermined light;
a lighting body made of a thermally conductive material, the lighting body having an installation space with an open front side for installing the LED unit, and a plurality of press-fitting portions integrally formed on a rear surface thereof in the form of a pair of slot ribs extending in a vertical direction; and
a plurality of heat dissipation units, each having a refrigerant flow space formed therein and filled with a refrigerant, the heat dissipation units being press-fitted into the press-fitting portions by an interference-fit method such that at least a portion of the refrigerant flow space is positioned within the pair of slot ribs of the corresponding press-fitting portion.

2. The lighting apparatus of claim 1,
wherein the heat dissipation unit comprises:
a first-side heat conduction panel forming one side surface of the refrigerant flow space in a thickness direction; and
a second-side heat conduction panel forming the other side surface of the refrigerant flow space in the thickness direction, and
wherein the refrigerant flow space is formed by joining the first-side heat conduction panel and the second-side heat conduction panel along peripheral edges thereof, the first-side and second-side heat conduction panels being formed of two metal panel members, or by bending a single metal panel member and then joining the first-side heat conduction panel and the second-side heat conduction panel to each other along peripheral edges thereof.

3. The lighting apparatus of claim 2, wherein the metal panel members constituting the first-side heat conduction panel and the second-side heat conduction panel are made of SUS (stainless steel).

4. The lighting apparatus of any one of claims 1 to 3,
wherein the refrigerant flow space provided in the heat dissipation unit comprises:
a first refrigerant flow path provided in an evaporation region in which liquid refrigerant of the refrigerant is stored and the stored liquid refrigerant is phase-changed into a gas state by heat supplied from the LED unit; and
a plurality of second refrigerant flow paths formed toward the first refrigerant flow path in a direction of gravity or inclined with respect to the direction of gravity, and configured to guide the liquid refrigerant of the refrigerant, which has been phase-changed from the gas state to the liquid state, to flow toward the first refrigerant flow path.

5. The lighting apparatus of claim 4, wherein the refrigerant is water capable of undergoing a phase change from the liquid state to the gas state or from the gas state to the liquid state by thermal conductivity of the first-side heat conduction panel forming one side surface of the refrigerant flow space and the second-side heat conduction panel forming the other side surface of the refrigerant flow space.

6. The lighting apparatus of claim 4, wherein, when the first refrigerant flow path of each of the plurality of heat dissipation units is press-fitted into a corresponding one of the plurality of press-fitting portions arranged on the rear surface of the lighting body so as to be spaced apart from each other in a left-right direction, the first refrigerant flow path is arranged vertically in an up-down direction corresponding to the direction of gravity.

7. The lighting apparatus of claim 4, wherein the plurality of second refrigerant flow paths are respectively defined to be partitioned from adjacent second refrigerant flow paths by a plurality of inclined guides protruding inwardly into the refrigerant flow space from the first-side heat conduction panel forming one side surface of the refrigerant flow space and the second-side heat conduction panel forming the other side surface of the refrigerant flow space.

8. The lighting apparatus of claim 7, wherein, in the second refrigerant flow path or the plurality of inclined guides, at least one of a first end and a second end is connected to the first refrigerant flow path, and an end connected to the first refrigerant flow path is positioned relatively lower in the direction of gravity.

9. The lighting apparatus of claim 7, wherein, in the second refrigerant flow path or the plurality of inclined guides, at least one of the first end and the second end is connected to the first refrigerant flow path, and the first end and the second end are connected in a straight line.

10. The lighting apparatus of claim 7, wherein the refrigerant flow space further comprises:
a plurality of third refrigerant flow paths defined as portions of opposing surfaces of the first-side heat conduction panel and the second-side heat conduction panel at which the plurality of inclined guides are formed, the portions being spaced apart from each other without being joined within the refrigerant flow space.

11. The lighting apparatus of claim 10,
wherein liquid refrigerant condensed in a condensation region other than the evaporation region flows in the liquid state in the direction of gravity along the plurality of inclined guides defining the second refrigerant flow paths, and
gas refrigerant evaporated in the evaporation region flows in the gas state through spaces between the plurality of inclined guides defining the third refrigerant flow paths.

12. The lighting apparatus of claim 7, wherein the first-side heat conduction panel and the second-side heat conduction panel are formed with a plurality of strength reinforcing portions protruding so as to be in surface contact with each other within the refrigerant flow space, thereby reinforcing the strength of the first-side heat conduction panel and the second-side heat conduction panel.

13. The lighting apparatus of claim 12, wherein the plurality of strength reinforcing portions are formed such that end surfaces thereof protrude into the refrigerant flow space by at least a greater extent than leading ends of the plurality of inclined guides.

14. The lighting apparatus of claim 12, wherein the plurality of strength reinforcing portions are joined at portions thereof that are in surface contact with each other within the refrigerant flow space by a joining process including a laser welding process, thereby forming the refrigerant flow space between the first-side heat conduction panel and the second-side heat conduction panel.

15. The lighting apparatus of claim 7, wherein the heat dissipation unit further comprises:
an absorber disposed within the first refrigerant flow path and having a plurality of pores to absorb liquid refrigerant within the refrigerant flow space and then evaporate the absorbed liquid refrigerant into gas refrigerant using heat transferred from the LED unit.

16. The lighting apparatus of claim 15, wherein the heat dissipation unit further comprises:
at least one auxiliary absorber disposed in a second refrigerant flow path on adjacent inclined guides among the plurality of inclined guides, the auxiliary absorber being configured to collect liquid refrigerant and supply the collected liquid refrigerant to the absorber.

17. The lighting apparatus of claim 1, further comprising:
an angle adjustment unit disposed at a lower end of the lighting body and configured to adjust an irradiation direction of the LED unit.

18. The lighting apparatus of claim 17, wherein the angle adjustment unit comprises:
a fixing bracket configured to fix the lighting body at a predetermined position;
a steering block configured to be steered and rotated in a left-right direction with respect to the fixing bracket about a vertical axis; and
a tilting block configured to be tilted and rotated in a front-rear direction with respect to the steering block via a horizontal left-right coupling shaft, the tilting block being connected to a lower end of the lighting body.

19. The lighting apparatus of claim 18, wherein the steering block is rotatably coupled to the fixing bracket through a fixing panel coupled to a lower portion of the fixing bracket while a lower end of the steering block is inserted into an installation hole formed through the fixing bracket in an up-down direction.

20. The lighting apparatus of claim 18,
wherein the steering block is provided with a steering worm wheel gear having a plurality of worm wheel gear teeth formed on a portion of an outer circumferential surface thereof,
wherein the fixing bracket is rotatably provided with a steering worm gear having worm gear teeth formed thereon to be engageable with the worm wheel gear teeth of the steering worm wheel gear, and
wherein the steering block is steered and rotated in a left-right direction as the steering worm gear rotates about an axis thereof.

21. The lighting apparatus of claim 18,
wherein the steering block is provided with a tilting worm wheel gear having a plurality of worm wheel gear teeth formed on a portion of an outer circumferential surface thereof,
wherein the tilting block is rotatably provided with a tilting worm gear having worm gear teeth formed thereon so as to be engageable with the worm wheel gear teeth of the tilting worm wheel gear, and
wherein the tilting block is tilted and rotated in a front-rear direction as the tilting worm gear rotates about an axis thereof.

22. The lighting apparatus of claim 17, wherein the angle adjustment unit comprises:
a housing base panel part configured to fix the lighting body, which requires tilting or steering adjustment, at a predetermined position;
a steering base panel configured to be steered and rotated in a left-right direction with respect to the housing base panel part about a steering shaft extending in a vertical direction; and
a tilting bracket panel configured to be tilted and rotated in a front-rear direction with respect to the steering base panel via a horizontally extending tilting shaft, the tilting bracket panel being connected to a lower end of the lighting body.

23. The lighting apparatus of claim 17, wherein the angle adjustment unit comprises:
a tilting rotation panel part fixed to the lighting body and configured to tilt and rotate in a front-rear direction in conjunction with the lighting body; and
a steering rotation panel part steerably and rotatably coupled to an installation portion on which the lighting apparatus is installed and configured to provide any left-right horizontal axis to the tilting rotation panel part.
